# EUROPEAN PATENT APPLICATION

(11) **EP 4 498 538 A1**
(43) Date of publication of application: **29.01.2025**
(21) Application number: 24189401.3
(22) Date of filing: 18.07.2024
(51) Int. Cl.: H01S 5/0625, H01S 5/068, H01S 5/02345, H01S 5/026, H01S 5/06, H01S 5/40

(54) **MULTIPLE OPTOELECTRONIC DEVICES WITH THERMAL COMPENSATION**

(30) Priority: 28.07.2023 US 202318361421
(71) Applicant: Freedom Photonics LLC, Irvine 92614 (US)
(72) Inventor: MORRISON, Gordon Barbour, Goleta, CA, 93117 (US); KEBORT, Donald J., Goleta, CA, 93117 (US)
(74) Representative: Purdylucey Intellectual Property

(57) **Abstract**

An optical apparatus comprising at least two optoelectronic devices fabricated on the same substrate and in thermal communication with each other. A first optoelectronic device is configured to generate optical signals and provide them to an optical system via an optical output port. A second optoelectronic device is configured to provide heat compensation for the first optoelectronic device. An electrical circuitry provides first electrical signals to the first optoelectronic device and second electrical signals to the second optoelectronic device. The electrical circuitry is configured to adjust at least the second electrical signals to controllably adjust a temperature of the first optoelectronic device.

## Description

### INCORPORATION BY REFERENCE TO ANY PRIORITY APPLICATIONS

This application is a continuation in part of US Patent Application No. 18/167777, filed February 10, 2023, entitled "MULTIPLE OPTOELECTRONIC DEVICES WITH THERMAL COMPENSATION", which is a continuation of U.S. Patent Application No. 17/062,462, filed October 2, 2020, entitled "MULTIPLE OPTOELECTRONIC DEVICES WITH THERMAL COMPENSATION", and issued February 14, 2023 as U. S. Patent No. 11581700, which claims the benefit of priority to U.S. Provisional Application No. 62/910,826 filed on October 4, 2019 titled "MULTIPLE OPTOELECTRONIC DEVICES WITH THERMAL COMPENSATION". The entire contents of each of the above-identified patent applications are hereby incorporated by reference herein.

### BACKGROUND

The aspect ratios and fabrication methods of optoelectronic devices (e.g., tunable lasers and tunable laser transmitters) can result in excess real estate relative to the size of the optoelectronic device. For example, most single-mode tunable lasers and tunable laser transmitters have a waveguide ridge that is approximately 1 micron to 7 microns wide, whereas a typical transmitter chip on which the optoelectronic device is fabricated is configured for cleaving and handling and has a width in a range of 100 microns to 500 microns (e.g., in a range of 250 microns to 500 microns). A defect in any part of the optoelectronic device can cause the entire chip to be discarded, resulting in decreased yield and increased manufacturing costs.

Furthermore, a smaller footprint for the optoelectronic device may not be compatible with good thermal management. Accordingly, while larger chips with greater surface area can advantageously help with heat dissipation, such chips can have a larger amount of wasted space.

### SUMMARY

In an aspect described herein, an apparatus (e.g., optical system) comprises at least a first optoelectronic device and a second optoelectronic device, the first and second optoelectronic devices in thermal communication with one another (e.g., the first and second optoelectronic devices are formed on the same substrate, wafer, or chip). The apparatus (optical system) further comprises an optical output port in optical communication with the first optoelectronic device and configured to be in optical communication with an optical system (e.g., via an optical adapter, optical fiber connector, or free space optical coupler; the optical system outside of a package or housing containing the first and second optoelectronic devices). The apparatus further comprises (e.g., within the package or housing) electrical (or electronic) circuitry in electrical communication with the first optoelectronic device, the electrical circuitry configured to provide first electrical signals to the first optoelectronic device, the first optoelectronic device responsive to the first electrical signals by generating optical signals and heat. The electrical circuitry is further in electrical communication with the second optoelectronic device, the electrical circuitry configured to provide second electrical signals to the second optoelectronic device, the second optoelectronic device responsive to the second electrical signals by generating heat. The electrical circuitry is configured to controllably adjust the first electrical signals and the second electrical signals to controllably adjust a temperature of the first optoelectronic device. The electrical circuitry is further configured to adjust the second electrical signals to control heat compensation produced by the second optoelectronic device.

In another aspect described herein, a method for fabricating an apparatus comprises providing a substrate comprising at least a first optoelectronic device and a second optoelectronic device, the first and second optoelectronic devices in thermal communication with one another. The method further comprises connecting the first and second optoelectronic devices to electrical circuitry configured to provide first electrical signals to the first optoelectronic device, the first optoelectronic device responsive to the first electrical signals by generating optical signals and heat. The electrical circuitry is further configured to provide second electrical signals to the second optoelectronic device, the second optoelectronic device responsive to the second electrical signals at least by generating heat. The electrical circuitry is further configured to control the first and second electrical signals such that a temperature of the first optoelectronic device is controlled (e.g., the temperature of the first optoelectronic device remains substantially constant). The method further comprises establishing an optical communication between the first optoelectronic device and an optical system and not establishing an optical communication between the second optoelectronic device and the optical system.

In another aspect described herein, a method for operating an apparatus comprises providing an apparatus comprising at least a first optoelectronic device and a second optoelectronic device, the first and second optoelectronic devices in thermal communication with one another. The method further comprises operating the first optoelectronic device to generate optical signals and heat and operating the second optoelectronic device to at least generate heat. The first and second optoelectronic devices are operated such that the heat generated by the first and second optoelectronic devices controls a temperature of the first optoelectronic device (e.g., the temperature of the first optoelectronic device) remains substantially constant. For examples, the temperature of the first device may be controlled such that a temperature of the first optoelectronic device (e.g., one or more sections of the first optoelectronic device) remain within ± 1%, ± 2%, ± 3%, ± 4%, ± 5%, ± 6%, ± 7%, ± 8%, , ± 10% or ± 20% of a target temperature, or any range between any of these values.

In another aspect described herein, the designs of the first and second optoelectronic devices can be substantially similar to one another, such that each section of the second optoelectronic device has a part that can be biased to compensate heating resulting from providing an injection current to a corresponding section of the first optoelectronic device configure (e.g., packaged, provided with optical coupling elements) to provide optical signals. In another aspect described herein, one or more sections of the second optoelectronic device can be configured to provide temperature-controlled tuning of the one or more sections of the first optoelectronic device (e.g., for fast tuning of swept SGDBRs) and/or to reduce or minimize thermal crosstalk between sections of the first optoelectronic device (e.g., to allow a comb mirror of the first optoelectronic device to be used as a reference).

In another aspect, an apparatus including an optoelectronic device configured to generate optical signals, a heat compensating device in thermal communication with the optoelectronic device. The apparatus further comprises an electrical circuitry configured to provide at least a first electrical signal to the optoelectronic device and at least a second electrical signal to the heat compensating device to controllably adjust a temperature of the optoelectronic device. The electrical circuitry is further configured to adjust a signal property of the second electrical signal based at least in part on a signal property of the first electrical signal to reduce a delay between a change in the second electrical signal and a corresponding adjustment in the temperature of the optoelectronic device.

In another aspect an apparatus including an optoelectronic device configured to generate optical signals, a heat compensating device in thermal communication with the optoelectronic device, said heat compensating device having a current-voltage characteristic. The apparatus further includes an electrical circuitry configured to provide at least a first electrical signal to the optoelectronic device and at least a second electrical signal to the heat compensating device to controllably adjust a temperature of the optoelectronic device. The electrical circuitry is further configured to adjust a signal property of the second electrical signal non-symmetrically based at least in part on the current-voltage characteristic of the heat compensating device.

### BRIEF DESCRIPTION OF THE DRAWINGS

In the following description of the various embodiments, reference is made to the accompanying drawings which form a part hereof, and in which is shown by way of illustration various embodiments of the device. It is to be understood that other embodiments may be utilized and structural changes may be made.
Figure 1A illustrates an example apparatus comprising a first optoelectronic device, a second optoelectronic device and an electrical circuitry where the first optoelectronic device is in optical communication with an optical system.
Figure 1B illustrates an example apparatus comprising a first optoelectronic device, a second optoelectronic device and an electrical circuitry where the first optoelectronic device is in optical communication with an optical system via an optical coupler.
Figure 2A illustrates a top view of an example chip with a first tunable laser and a second tunable laser where each tunable laser include two mirrors, a phase section, a gain section, an optical amplifier, and a rear absorber.
Figure 2B illustrates a top view of an example chip with a first tunable laser transmitter and a second tunable laser transmitter where each tunable laser transmitter include two mirrors, a phase section, a gain section, an optical amplifier, a rear absorber and a modulator.
Figure 3 illustrates example relative changes to injection electrical currents provide to the front mirror, back mirror, and phase section of a tunable laser or tunable laser transmitter to tune the wavelength of an optical signal generated by the tunable laser transmitter.
Figure 4 illustrates heat generated by a section of a first optoelectronic device, heat generated by a section of a second optoelectronic device and combined heat generated by the two sections when injection electrical currents provided to the section of the first optoelectronic device and to the section of the second optoelectronic device are modulated with opposite phase.
Figure 5A schematically illustrates a configuration of a chip comprising two optoelectronic devices mounted on a carrier and wire bonded to the electrical ports of a carrier such that device on the left is wire bonded to ports for the active device, and the device on the right is wire bonded to ports for the compensation heat control.
Figure 5B schematically illustrates a configuration of a chip comprising two optoelectronic devices mounted on a carrier and wire bonded to the electrical ports of a carrier such that the device on the right is wire bonded to ports for the active device, and the device on the left is wire bonded to ports for the compensation heat control.
FIG. 6 is a flow diagram of an example fabrication method of an apparatus comprising two optoelectronic devices by selecting and connecting first optoelectronic device to a circuitry for optoelectronic control and selecting and connecting a second optoelectronic device to a circuitry for producing heat compensation for the first optoelectronic device.
Figure 7A schematically illustrates heat dissipation rate by an optoelectronic device as a function of the electrical current (I) provided to the optoelectronic device.
Figure 7B schematically illustrates an apparatus comprising a heat dissipating optoelectronic device in thermal communication with a light generating optoelectronic device.
Figures 8A and 8B schematically illustrate two example temporal variations of the electrical current (I₂) provided to a heat compensating device and the resulting changes in the heat transfer rate (H₂₁) from the heat compensating device to an optoelectronic device. A) The electrical current is increased to provide heat to the optoelectronic device. B) The electrical current is reduced to absorb heat from the optoelectronic device. The solid and dashed lines represent electrical current variations that result in fast and delayed thermal control respectively.
Figure 8C shows temporal variation of electric current (I₁) provided to a section of the first optoelectronic device (e.g., the light generating device) and two example temporal variations of modified (e.g., pre-emphasized) electric current (I₂) provided to a section of the second optoelectronic device (e.g., the heat compensating device) to stabilize the temperature of the first optoelectronic device.

### DETAILED DESCRIPTION

Certain embodiments described herein advantageously utilize space on an optoelectronic chip (e.g., substrate; wafer) that would otherwise be wasted to improve the yield of usable devices. For example, the empty space on a substrate not occupied by a first optoelectronic device (e.g., a tunable laser or tunable laser transmitter) can be utilized by fabricating at least one second optoelectronic device (e.g., similar or identical to the first optoelectronic device) on the same chip (e.g., substrate; wafer) in thermal communication with the first optoelectronic device and using a selected one of the first and the at least one second optoelectronic devices to generate optical signals (e.g., selected based on the optical properties and/or performance of the first and the at least one second optoelectronic devices) and using the other of the first and at least one second optoelectronic device to provide thermal compensation for the first optoelectronic device. By including the at least one second optoelectronic device on the available excess real estate and allowing one of the two or more optoelectronic devices to be selected to generate optical signals, the chip yield can be increased, and manufacturing costs can be decreased. Additionally, the optoelectronic device selected for providing heat compensation may improve the performance of the optoelectronic, device selected for generating optical signals, by stabilizing a temperature of one or more sections of the optoelectronic device selected for generating optical signals. In some examples, stabilizing the temperature of one or more sections of the optoelectronic device selected for generating optical signals, may facilitate tuning or adjusting the wavelength of optical signals (e.g., enable monotonous wavelength tuning within a given wavelength range). In some examples, stabilizing the temperature of one or more sections of the optoelectronic device selected for generating optical signals may improve the stability of a power or an intensity of the generated optical signals. For example, the heat compensation provided by the optoelectronic device, selected for heat compensation, may maintain the optical intensity or optical power within ± 1%, ± 2%, ± 3%, ± 4%, ± 5%, ± 6%, ± 7%, ± 8%, , ± 10% or ± 20% of a target optical intensity or optical power, or any range between any of these values. In some examples, stabilizing the temperature of one or more sections of the optoelectronic device, selected for generating optical signals, may improve the stability of a wavelength of optical signals. For example, the heat compensation provided by the second optoelectronic device may maintain the wavelength of the optical signals within ± 1%, ± 2%, ± 3%, ± 4%, ± 5%, ± 6%, ± 7%, ± 8%, ± 10% or ± 20% of a target wavelength, or any range between any of these values.

Certain embodiments described herein provide an advantageous improvement in yield. For example, if a defect in one of the two or more optoelectronic devices occurs, another non-defective optoelectronic device of the two or more optoelectronic devices can be used for generating optical signals, while the defective optoelectronic device can be used (e.g., primarily or solely) for thermal compensation of the non-defective optoelectronic device. For another example, if one of the two or more optoelectronic devices is sub-optimal, another optimal optoelectronic device of the two or more optoelectronic devices can be used to generate optical signals (e.g., packaged to provide optical signals), while the sub-optimal optoelectronic device is used (e.g., primarily or solely) for thermal compensation of the optimal optoelectronic device that is generating optical signals. For still another example, the two or more optoelectronic devices can have different designs from one another (e.g., variations of parameter space for the different optoelectronic devices), and the optoelectronic device having a preferred, better, best, etc. operation (e.g., such as higher or lower based on a selected metric, for example, temporal variation of an optical intensity or optical power and/or wavelength of the optical signals generated by the optoelectronic device.) among the two or more optoelectronic devices can be used to generate optical signals (e.g., packaged to provide optical signals), while an optoelectronic device not having the preferred, better or best operation (e.g., such as higher or lower based on a selected metric, for example, temporal variation of an optical intensity or optical power and/or wavelength of the optical signals generated by the optoelectronic device) is used (e.g., primarily or solely) for thermal compensation of the optoelectronic device having the preferred, better or best optical operation and that is generating optical signals. For yet another example, the two or more optoelectronic devices can have different designs from one another, and the optoelectronic device having the desired operation can be used (e.g., packaged to provide optical signals), while an optoelectronic device not having the desired operation is used (e.g., primarily or solely) for thermal compensation of the optoelectronic device having the desired operation, resulting in an advantageous improvement in inventory management.

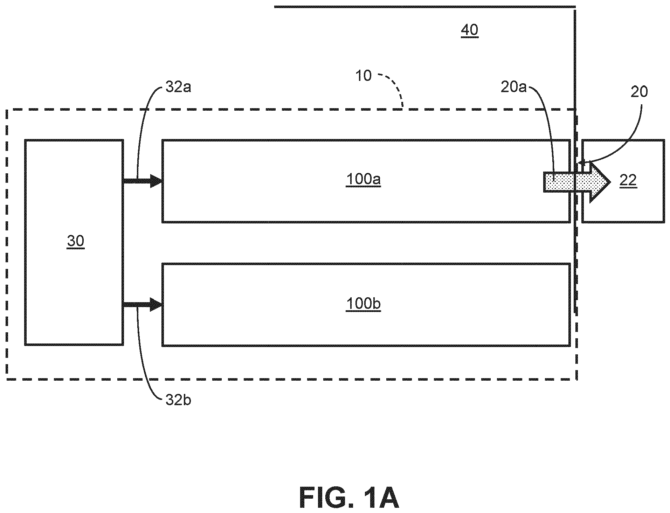

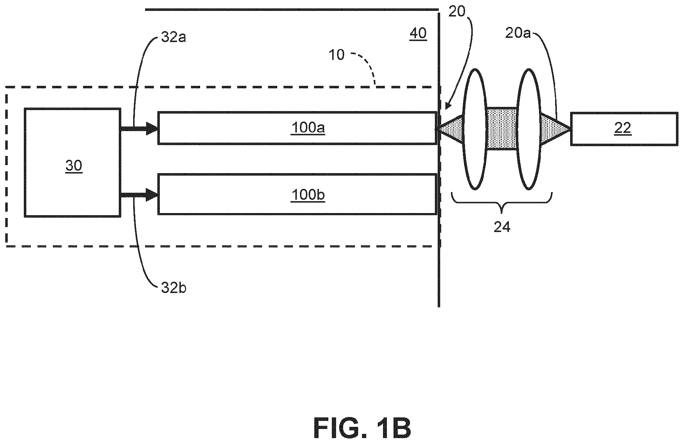

FIGs. 1A and 1B schematically illustrate an example apparatus 10 in accordance with certain embodiments described herein. The apparatus 10 comprises at least a first optoelectronic device 100a and a second optoelectronic device 100b, the first and second optoelectronic devices 100a, 100b in thermal communication with one another (e.g., the first and second optoelectronic devices 100a, 100b are formed on the same chip 40 (e.g., substrate; wafer). The apparatus 10 further comprises an optical output port 20 in optical communication with the first optoelectronic device 100a and configured configure to output light or optical signals generated by the first optoelectronic device 100a. In some embodiments, the optical output port may be configured to be in optical communication with an optical system 22 (e.g., via an optical coupler 24).

The apparatus 10 further comprises electrical circuitry 30 in electrical communication with the first optoelectronic device 100a, the electrical circuitry 30 configured to provide first electrical signals 32a to the first optoelectronic device 100a, the first optoelectronic device 100a responsive to the first electrical signals 32a by generating optical signals 20a and heat. The electrical circuitry 30 is further in electrical communication with the second optoelectronic device 100b, the electrical circuitry 30 configured to provide second electrical signals 32b to the second optoelectronic device 100b, the second optoelectronic device 100b responsive to the second electrical signals 32b by generating heat. The electrical circuitry 30 is configured to controllably adjust the first electrical signals 32a and the second electrical signals 32b to controllably adjust a temperature of the first optoelectronic device 100a.

In certain embodiments, one or both of the first optoelectronic device 100a and the second optoelectronic device 100b comprises a tunable laser. For example, the tunable laser can include a waveguide with active and passive sections including at least one mirror (or optical reflector) comprising an optical grating, at least one optical gain section, and at least one output facet. In some examples, the output face may be partially reflecting. For another example, the tunable laser can include two mirrors (optical reflectors), a phase section, and an optical gain section. For still another example, the tunable laser can include a semiconductor optical amplifier (SOA) (e.g., the first optoelectronic device 100a can include a distributed feedback laser with an SOA output, where wavelength tuning and power tuning can be thermally compensated by the second optoelectronic device 100b) and/or an electro-absorption modulator. In certain other embodiments, one or both of the first optoelectronic device 100a and the second optoelectronic device 100b may comprise a tunable laser transmitter (e.g., a tunable laser with an optical modulator).

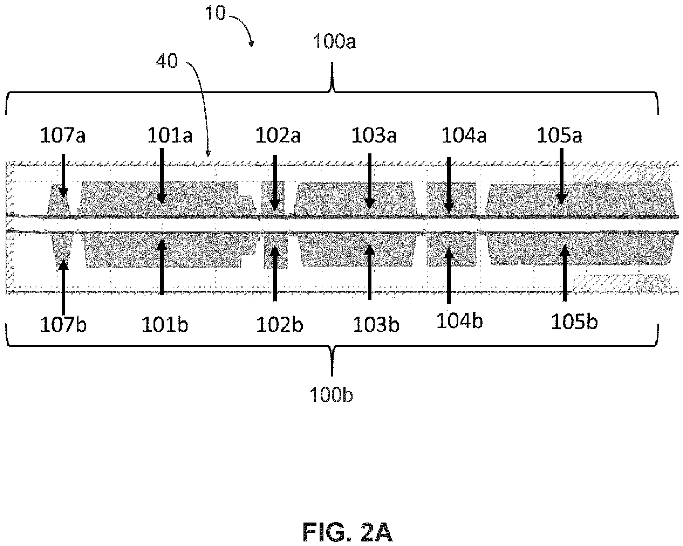

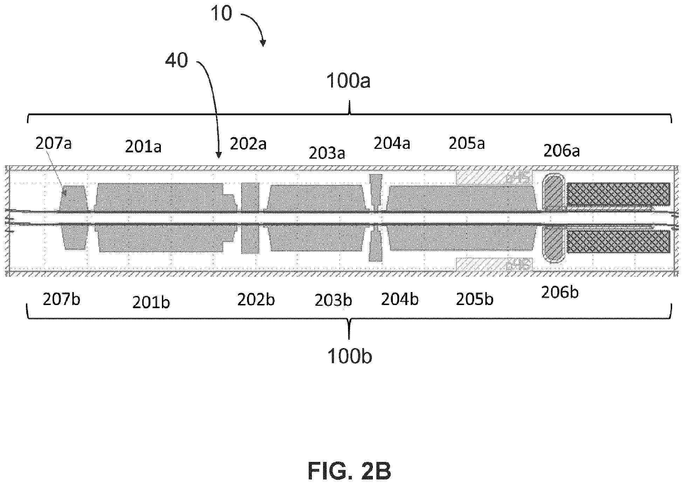

FIG. 2A schematically illustrates a top view of an example apparatus 10 in accordance with certain embodiments described herein. In FIG. 2A, the first and second optoelectronic devices 100a, 100b each comprise a tunable laser. In FIG. 2B, the first and second optoelectronic devices 100a, 100b each comprise a tunable laser transmitter. In FIGs. 2A and 2B, the two optoelectronic devices 100a, 100b are fabricated on a single chip 40. For example, the single chip 40 can have a minimum fabrication size (e.g., due to manufacturing constraints, the chip 40 would not be any smaller in footprint if it comprised only a single optoelectronic device). In certain embodiments, the two optoelectronic devices 100a, 100b (e.g., tunable lasers; tunable laser transmitters) are included on a single chip 40 that would otherwise have supported a single optoelectronic device. Similarly, in certain embodiments, the two optoelectronic devices 100a, 100b (e.g., tunable lasers; tunable laser transmitters) are included on a single chip 40 that would otherwise have supported two or more optoelectronic devices.

As schematically illustrated by FIG. 2A, in some embodiments, the first optoelectronic device 100a comprises a tunable laser including two first mirrors 101a, 104a, a first phase section 102a, a first gain section 103a, a first semiconductor optical amplifier 105a, and a first rear absorber 107a. The second optoelectronic device 100b can be fabricated in a portion of the chip 40 that would otherwise be unused and the second optoelectronic device 100b can be similar (e.g., identical) to the first optoelectronic device 100a. For example, the second optoelectronic device 100b can comprise components that would be equally useful as a tunable laser, which as shown in FIG. 2A, can include two second mirrors 101b, 104b, a second phase section 102b, a second gain section 103b, a second semiconductor optical amplifier 105b, and a second rear absorber 107b. As schematically illustrated by FIG. 2B, the first optoelectronic device 100a comprises a tunable laser transmitter including two first mirrors 201a, 204a, a first phase section 202a, a first gain section 203a, a first semiconductor optical amplifier 205a, a first rear absorber 207a, and a first modulator 206a. The second optoelectronic device 100b can be fabricated in a portion of the chip 40 that would otherwise be unused and the second optoelectronic device 100b can be similar (e.g., have the same components of the similar or the same or identical size and/or shape or other characteristics such as electrical, material, or spatial characteristics) to the first optoelectronic device 100a. For example, the second optoelectronic device 100b can comprise components that would be equally useful as a tunable laser transmitter, which as shown in FIG. 2B, can include two second mirrors 201b, 204b, a second phase section 202b, a second gain section 203b, a second semiconductor optical amplifier 205b, a second rear absorber 207b, and a second modulator 206b. In some embodiments, an optoelectronic device may comprise plurality of sections. In some such embodiments, each section may comprise one or more components (e.g., mirror, optical reflector, phase shifter, optical amplifier, optical absorber, optical gain and the like). In some cases, one or more temperature sensors may be included (e.g., monolithically integrated) with an optoelectronic device. In some such cases, one or more sections, possibly most or even each section, may include a temperature sensor that may be used to monitor or measure the temperature of that section. A temperature sensor can be, for example, a thermistor, a thermocouple, or a semiconductor temperature sensor (e.g., a semiconductor junction).

Due to the aspect ratios of the first and second optoelectronic devices 100a, 100b, and the constraints imposed by packaging and cleaving systems, the practical and convenient chip size is much larger than the size of the individual first optoelectronic device 100a. Thus, there may be a significant amount of space on the chip 40 that is unused and does not include any optoelectronic components and/or functional blocks included in the first optoelectronic device 100a.

In certain embodiments, the two optoelectronic devices 100a, 100b are tested (e.g., prior to further packaging). If a defect in one of the two optoelectronic devices 100a, 100b renders it unusable for generating optical signals, it is possible that the other of the two optoelectronic device 100a, 100b is usable for generating optical signals, and further packaging comprises configuring the usable optoelectronic device for electrical connection (e.g., in electrical communication with circuitry 30) and for optical connection (e.g., in optical communication with optical system 22), while the unusable optoelectronic device is not configured for generating optical signals. In certain embodiments, the two optoelectronic devices 100a, 100b are tested (e.g., prior to further packaging), and the optoelectronic device with certain optical performance may be selected for optical connection, while the other optoelectronic device ultimately is not used for generating optical signals.

In certain embodiments, if the first optoelectronic device 100a is tested and meets all requirements, testing of the second optoelectronic device 100b can be omitted (e.g., is not required), and the first optoelectronic device 100a can selected to be electrically connected to an electrical circuit and to be in optical communication with an optical system, while the second optoelectronic device 100b, although it may be operational (e.g., capable of generating optical signals), may not be configured for generating optical signals. In some examples, the second optoelectronic device may generate light or optical signals but not being optical communication with an optical system. In some examples, current may be provided only to selected sections of the second optoelectronic device (e.g., to generate heat and provide heat compensation for the second optoelectronic device).

In certain embodiments, designing and manufacturing optoelectronic devices (e.g., tunable lasers; tunable laser transmitters) can advantageously provide two slightly different optoelectronic devices (e.g., different versions of the same optoelectronic device) that can be simultaneously fabricated. For example, during a testing phase in which the two optoelectronic devices 100a, 100b are tested (e.g., by measuring an intensity, power or a wavelength of optical signals generated by the optoelectronic device), one of the two optoelectronic devices 100a, 100b can be selected based on the test results and on the desired application. The one of the two optoelectronic devices with better optical performance can be selected to be further configured to be in optical communication with an optical system 22 (e.g., via an output optical fiber) while the other non-selected optoelectronic device, although present on the chip 40 and in the device package, is not in optical communication with the optical system 22. In certain such embodiments, both the selected optoelectronic device and the non-selected optoelectronic device are provided with electrical connections and input electrical signals, with the non-selected optoelectronic device used to provide temperature control for the selected optoelectronic device. In some examples, an optical performance may be measured at least in part based on a measured intensity or power of the optoelectronic device and/or a measured wavelength of the optoelectronic device. In some examples an optical performance may be measured at least in part based on a temporal variation of measured intensity or power of the optoelectronic device and/or a temporal variation of the measured wavelength of the optoelectronic device. In some cases, a better performance is a measured performance that is different from another measured performance by a threshold value.

In certain embodiments, operation of the optoelectronic device that is in optical communication with the optical system 22 via the optical output port 20 (e.g., the first optoelectronic device 100a) comprises adjusting (e.g., changing; tuning; modifying) at least one electrical signal 32a (e.g., electrical currents) provided to at least one component of the first optoelectronic device 100a. Such adjustments of the at least one electrical current or voltage provided to the optoelectronic device can be used to, for example, adjust a wavelength of the optical signals generated by the optoelectronic device or to adjust the intensity or power of light output by the optoelectronic device. In some cases, an adjustment of the at least one electrical current or voltage provided to the optoelectronic device may comprise modulating the electrical current of the electrical voltage at a modulation frequency. In some examples the modulation frequency can be from 1 Hz to 100 Hz, 100 Hz to 1KHz, 1KHz to 100 KHz, 100 KHz to 1 MHz, 1 MHz to 100 MHz, 100 MHz to 1 GHz, 1 GHz to 10 GHz, or 10 GHz to 50 GHz or any range formed by any of these values.

In some cases, an adjustment of the at least one electrical current or voltage provided to the optoelectronic device can be used to compensate for aging of an active material in at least one component (e.g., gain section; phase section; one or more mirrors) over the lifetime of the optoelectronic device.

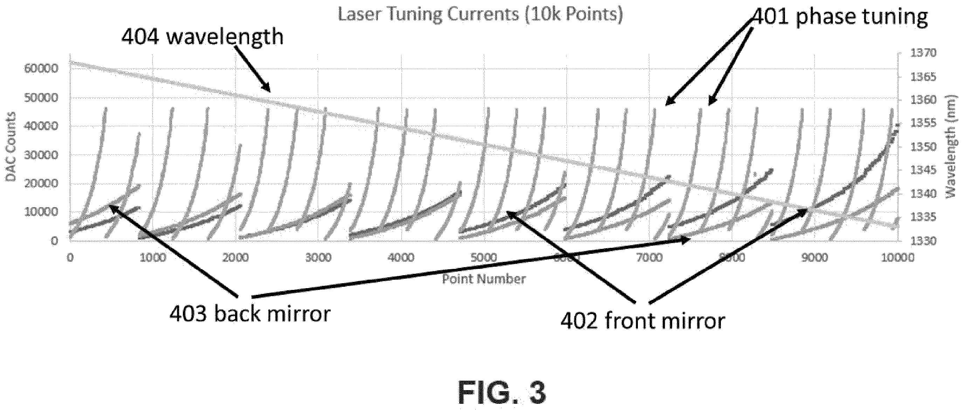

In some embodiments, at least one injection electrical current can be adjusted so as to sweep the first optoelectronic device 100a (e.g., Vernier-tuned tunable laser) through a continuum of wavelengths within a predetermined wavelength range. FIG. 3 schematically illustrates example relative changes to injection electrical currents provided to the front mirror 104a, back mirror 101a, and phase section 102a of a first optoelectronic device 100a in accordance with certain embodiments described herein. This ramping of the injection electrical currents provided to the front mirror 104a, back mirror 101a, and the phase section 102a can be complex, and in certain embodiments, electrical currents provided to the gain section 103a and/or the SOA 105a are also tuned to maintain power as the wavelength is adjusted. FIG. 3 shows the variation of the wavelength 404 of an example optoelectronic device (e.g., the first optoelectronic device 100a) as a result of adjusting the electrical current 401 provided to the phase section 102a for phase tuning, the electrical current 402 provided to the front mirror 104a, and the electrical current 403 provided to the back mirror 101a. In this plot, the x-axis represent points in time, the left-most y-axis represents the magnitude of electrical currents 401 provided to the phase section 102a for phase tuning, the electrical current 402 provided to the front mirror 104a, and the electrical current 403 provided to the back mirror 101, and the right-most y-axis represents the wavelength 404 of the first optoelectronic device 100a. FIG .3 shows that various currents provided to an optoelectronic device (e.g., the first optoelectronic device) may need to be adjusted in a complex manner in order to change the wavelength monotonously (e.g., as a linearly decreasing function) while maintaining the optical output power constant or within a limited or predefined range.

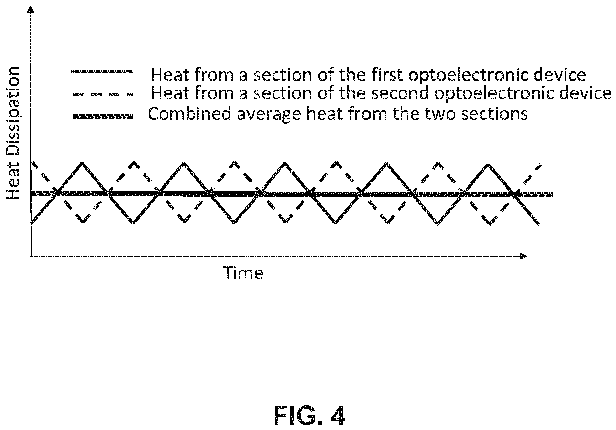

These changing injection electrical currents provided to various portions of the first optoelectronic device 100a induce corresponding temperature changes over time. Such temperature changes could affect the operation of the first optoelectronic device 100a. In some examples, these changing temperatures may interfere with the wavelength adjustment process and make it difficult to control the wavelength of the first optoelectronic device. Advantageously, in certain embodiments, the second optoelectronic device 100b may be used to reduce (e.g., prevent; mitigate; minimize) these temperature-induced effects by providing thermal compensation. In some embodiments, one or more second injection currents may be provided to one or more sections or components of the second optoelectronic device such that the heat exchange between the first optoelectronic device and the second optoelectronic device results in a constant or nearly constant temperature of one or more sections or the components of the first optoelectronic device that are adjusted using one or more first injection currents. For example, FIG. 4 schematically illustrates the temporal variation of heat dissipated or generated by a section of the first optoelectronic device and a section of the second optoelectronic device. In this example, the heat from each section could be generated as a result of modulating a first injection electrical current provided to a section of the first optoelectronic device 100a (e.g., a laser with its optical output 20 in optical communication with an optical system 22 and in electrical communication with the electrical circuitry 30) and modulating the second injection electrical current provided to a section of the second optoelectronic device 100b (e.g., a laser that is not in optical communication with the optical system 22 and that is in electrical communication with the electrical circuitry 30) in accordance with certain embodiments described herein. While the second optoelectronic device 100b is not in optical communication with the optical system 22 (e.g., optical signals generated by the second optoelectronic device 100b are unused), at least one injection electrical current provided to the second optoelectronic device 100b is used to compensate the changing heat generated by the first optoelectronic device 100a (e.g., to keep the temperature of the first optoelectronic device 100a within a predetermined range). As shown in FIG. 4, the summed heat generated and dissipated by both the first optoelectronic device 100a and the second optoelectronic device 100b is controlled (e.g., substantially constant; adjusted among different values) over time such that the temperature of the first optoelectronic device 100a is controlled (e.g., substantially constant; adjusted to a desired value or adjusted to remain within a particular range) over time.

In certain embodiments, the substantially constant temperature is maintained regardless of the drive currents being sourced to the first optoelectronic device 100a (e.g., the selected laser), which as described above, can change as a function of time. As one or more electrical currents provided to one or more sections of the first optoelectronic device 100a (e.g., currents to one or more sections 101a-107a) are driven downwards or upwards from a nominal value to tune or control the first optoelectronic device 100a (e.g., the laser wavelength, power, and/or side mode suppression ratio), one or more electrical currents provided to one or more corresponding sections of the second optoelectronic device 100b (e.g., currents to one or more sections 101b-107b) are driven by a similar amount upwards or downwards (or by an amount having a similar effect) in the opposite direction. Thus, in certain embodiments, by providing an opposite bias to the corresponding section of the second optoelectronic device 100b that is adjacent to the section of the first optoelectronic device 100a having the changing bias, the thermal load in any region of the chip 40 can remain substantially constant so that the temperature of the first optoelectronic device 100a remains substantially constant (e.g., does not vary significantly with changes to the device bias).

In certain embodiments, the first optoelectronic device 100a and the second optoelectronic device 100b are paired (e.g., mirror imaged) to one another on the chip 40 (and/or grouped and/or sufficiently close) such that the waveguides of the two optoelectronic devices 100a, 100b are in thermal communication with one another (e.g., spaced by a distance in a range of 2 microns to 100 microns; spaced by less than 100 microns) to improve uniformity of constant thermal load. In certain embodiments, the injection currents in one or more pairs of local sections (e.g., sections 101a, 101b; sections 102a, 102b; etc.) are balanced to compensate one another, thereby promoting or ensuring constant thermal load and enhanced temperature stability. In certain embodiments, thermal compensation is provided by pairing only a subset (e.g., one or two) of the sections 101a-107a of the first optoelectronic device 100a with corresponding sections 101b-107b of the second optoelectronic device 100b, while in certain other embodiments, thermal compensation is provided by pairing all of the sections 101a-107a of the first optoelectronic device 100a with corresponding sections 101b-107b of the second optoelectronic device 100b.

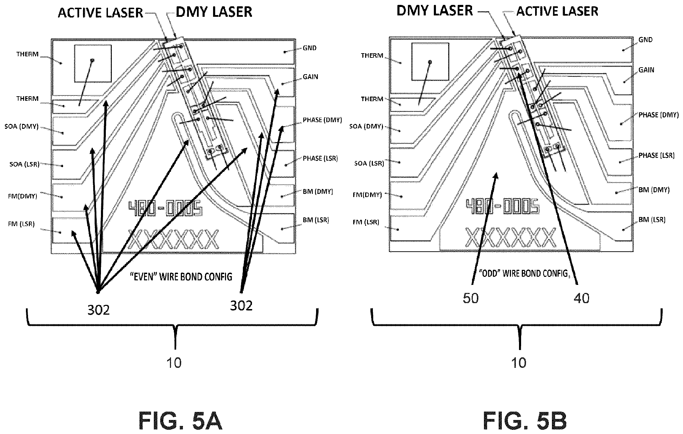

FIGs. 5A and 5B schematically illustrate two configurations of a chip 40 comprising two optoelectronic devices in accordance with certain embodiments described herein. The chip 40 (comprising, for example, III-V semiconductor material) is mounted on (e.g., soldered; epoxied; otherwise attached to) a carrier 50 (e.g., substrate) for thermal and mechanical stability. Either of the two optoelectronic devices on the chip 40 can be selected for optical connection to be used as the first optoelectronic device 100a (e.g., labeled "active laser" in FIGs. 5A and 5B) while the other of the two optoelectronic devices is selected to balance the thermal load to be used as the second optoelectronic device 100b (e.g., labeled "dmy laser" in FIGs. 5A and 5B). In certain embodiments, the selection is arbitrary, with the first optoelectronic device 100a interchangeable with the second optoelectronic device 100b. The two configurations of FIGs. 5A and 5B can be attained by using the same chip 40 and optoelectronic devices but with different connection configurations for the two configurations. For example, in the apparatus 10 of FIG. 5A, the left-most optoelectronic device on the chip 40 is wire bonded or otherwise connected to electrical ports 302 for the active device (e.g., first optoelectronic device 100a), and is subsequently optically connected to the optical system 22, while the right-most optoelectronic device on the chip 40 is wire bonded or otherwise connected to electrical ports for the compensation heat control (e.g., load-balancing) device and is not subsequently optically connected to the optical system 22. For another example, in the apparatus 10 of FIG. 5B, the right-most optoelectronic device on the chip 40 (e.g., first optoelectronic device 100a) is wire bonded or otherwise connected to electrical ports 302 for the active device, and is subsequently optically connected to the optical system 22, while the left-most optoelectronic device on the chip 40 is wire bonded or otherwise connected to electrical ports for the compensation heat control (e.g., load-balancing) device and is not subsequently optically connected to the optical system 22. In the configurations of FIGs. 5A and 5B, the roles of the two optoelectronic devices are switched relative to one another.

In certain embodiments, the electrical ports 302 are configured such that either of the configurations of FIGs. 5A and 5B can be readily implemented in the manufacturing process. In certain embodiments, one of the optoelectronic devices can have poor optical performance or not being optically functional (e.g., not being able to generate optical signals), but can still be electrically functional for generating heat for thermal compensation, and the selection of which of the configurations of FIGs. 5A and 5B is used can be based on a determination of which of the two optoelectronic devices has the preferred, better, best, etc., optical performance (e.g., such as higher or lower based on based on a selected metric such as: temporal variation of an intensity or power and/or wavelength of the optical signals generated by the optoelectronic device). In certain such embodiments, a higher yield of chips with thermal compensation is provided. In some examples, a better optical performance is an optical performance that is different from another optical performance by a threshold amount.

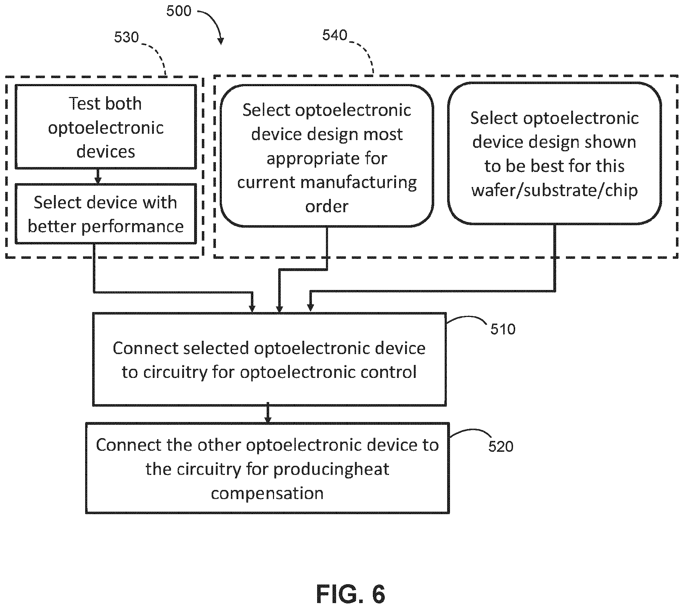

FIG. 6 is a flow diagram of an example method 500 in accordance with certain embodiments described herein.

In an operational block 510, the method 500 comprises connecting a first optoelectronic device 100a to electrical circuitry 30. The electrical circuitry 30 is configured to provide first electrical signals 32a to the first optoelectronic device 100a, the first electrical signals 32a configured to control optoelectronic operation of the first optoelectronic device 100a (e.g., to control the generation of optical signals 20a by the first optoelectronic device 100a). In an operational block 520, the method 500 further comprises connecting a second optoelectronic device 100b to the electrical circuitry 30. The electrical circuitry 30 is further configured to provide second electrical signals 32b to the second optoelectronic device 100b, the second electrical signals 32b configured to control heat compensation by the second optoelectronic device 100b. For example, the second electrical signals 32b can be configured to operate the second optoelectronic device 100b to generate a thermal load that is summed with a thermal load from the first optoelectronic device 100a such that a temperature of the first optoelectronic device 100a is controlled (e.g., substantially constant, with in a range) during operation of the first optoelectronic device 100a. In certain embodiments, the method 500 further comprises connecting an optical output port 20 of the first optoelectronic device 100a to an optical input port of an optical system 22 (e.g., via an optical coupler 24). In some examples, the optical output port may be connected to an optical connector (e.g., fiber optic connector) that is connected to optically coupled to the optical system. In some such examples the optical output port may be connected to an intermediary optical component (e.g., an optical adapter, a mode matching component and the like). In some other examples, the optical output port can be a facet or a mirror that couples light from the optoelectronic device to free space. In some such examples, the light coupled out by the output port may be coupled to an optical system using an intermediary optical system (e.g., comprising one or more one or more optical components such as lenses, polarizers, and the like).

In certain embodiments, method 500 comprises selecting one of two optoelectronic devices to use as the first optoelectronic device 100a. For example, in an operational block 530, the optical performance of both of the optoelectronic devices can be tested, and the optoelectronic device having the better, best, etc. optical performance (e.g., such as higher or lower based on a selected metric such as: temporal variation of an intensity or power and/or wavelength of the optical signals generated by the optoelectronic device) can be selected to use as the first optoelectronic device 100a. In some embodiments, testing the optoelectronic device may include but limited to: measuring the intensity or power of light output by the optoelectronic device as a function of one or more drive currents provided to the optoelectronic device, measuring the wavelength of light output by the optoelectronic device as a function of one or more drive currents provided to the optoelectronic device, measuring an optical modulation depth as a function of one or more modulating signals provided to optoelectronic device, monitoring the intensity or power of light output by the optoelectronic device over a period of time and the like. In some such embodiments, an optical performance of the optoelectronic device may be determined based at least in part on the measured intensity or power, measured optical modulation depth, variations in the intensity or power of measured light overtime and the like. In some examples, the testing procedure may comprise testing a first optical performance of the first optoelectronic device and a second optical performance of the second optoelectronic device. In some such examples, a better, best, etc. optical performance may comprise an optical performance that is different than another optical performance by a threshold amount.

In certain embodiments, the method 500 comprises selecting the first optoelectronic device 100a based on a design (e.g., the design most appropriate for the current manufacturing order and/or the design that is different than other designs on the same wafer/substrate/chip) of the first optoelectronic device in an operational block 540. In some examples, a design difference may be related to the size and shape of certain features of the device. For example, design differences between the first and second optoelectronic devices 100a, 100b can result in operational differences that make one device more useful for the particular application or operation of the apparatus 10 and the other device more useful for a different application or different operation. The determination of operational differences can be made after testing both the first and second optoelectronic devices 100a, 100b or can be based on the design differences, without testing both devices, where the design differences are known to result in operational differences or probabilities of operational differences. In some examples, the design difference can be a design of the fabricated device and can be associated with fabrication process. In some such examples, the design difference may be related to process variation from one wafer or substrate to another wafer or substrate. The device considered to be more useful for the particular operation of the apparatus 10 can be selected to be used as the first optoelectronic device 100a of the apparatus 10 while the other device considered to be more useful for a different application may be selected to be used as the second optoelectronic device 100b of the apparatus 10.

In some embodiments, once a first optoelectronic device is selected for generating optical signals, a second optoelectronic device is selected for producing heat compensation for the first optoelectronic device, and both optoelectronic devices are electrically connected to the electrical circuitry, the electrical circuitry may be configured, for example, by measuring temperatures of one or more sections of the first optoelectronic device. In some such embodiments, the electrical circuitry can be adjusted to provide electrical signals to the second optoelectronic device in order to maintain the measured temperature of one or more sections of the first optoelectronic device within a given temperature range while the first optoelectronic device is operational (e.g., generating optical signals, generating optical signals with varying intensity or power, generating optical signals with varying wavelengths and the like). In some examples, the temperature of one or more sections of the first optoelectronic device may be measured using one or more temperature sensors (e.g., thermistors, thermocouples, semiconductor temperature sensors or RTDs, and the like). In some such examples, the temperature sensors may be integrated with the first optoelectronic device. In some other examples, one or more temperature sensors may be temperature probes in thermal communication with one or more sections of the first optoelectronic device.

In some embodiments, once a first optoelectronic device is selected for generating optical signals, a second optoelectronic device is selected for producing heat compensation for the first optoelectronic device, and both optoelectronic devices are electrically connected to the electrical circuitry, the electrical circuitry may be configured, for example, by measuring the wavelength of the light generated by the first optoelectronic device. In some such embodiments, the electrical circuitry can be adjusted to provide electrical signals to the second optoelectronic device to enable tuning the measured wavelength within a given wavelength range. In some examples, enabling tuning the measured wavelength within a given wavelength range may comprise tuning the wavelength continuously within a wavelength range. In some examples, the wavelength of the optical signal generated by the first optoelectronic device may be measured using an optical spectrometer that is in optical communication with the first optoelectronic device (e.g., via an output port of the first optoelectronic device).

In some implementations, the second optoelectronic device 100b may be replaced by a device that is not capable of generating light. For example, an apparatus may comprise an optoelectronic device and a thermoelectric device (e.g., a resistive heater or a thermoelectric cooler) in thermal communication with the optoelectronic device. In such implementations, the apparatus may comprise one or more features described above with respect to apparatus 10. In some cases, similar to the second optoelectronic device 100b described above, the thermoelectric device may provide heat compensation to adjust the temperature of at least a section of the optoelectronic device; however, the thermoelectric device may not generate light. In some examples, the thermoelectric device may comprise one or more sections whose temperatures can be independently controlled. In some examples, an individual section of the thermoelectric device may be configured to provide thermal compensation to a corresponding section of the first optoelectronic device 100a. An electronic circuit or a controller (e.g., the electrical circuitry 30) may provide electrical currents (or voltages) to one or more sections of the thermoelectric device to controllably adjust the temperature of one or more sections of the first optoelectronic device 100a.

The heat compensating device may comprise, for example, a thermoelectric device such as a resistive heater comprising, for example, doped semiconductor such as a semiconductor junction, undoped or intrinsic semiconductor, metal such as low conductivity metal (e.g., tungsten). The resistive heater may include an input port for ingress of current and an output port for egress of current and/or for application of a voltage. Such components may be fabricated in or on a semiconductor substrate. The heat compensating device may also comprise other types of thermoelectric devices such as a thermoelectric cooler. In some cases, the resistive heater may comprise a film resistor (e.g., a thin film or a thick film resistor). In some examples, the resistive heater may comprise nichrome (NiCr) or other alloys. In some cases, the compensating device may comprise a semiconductor or a semiconductor junction.

### Controlling the heat compensating device

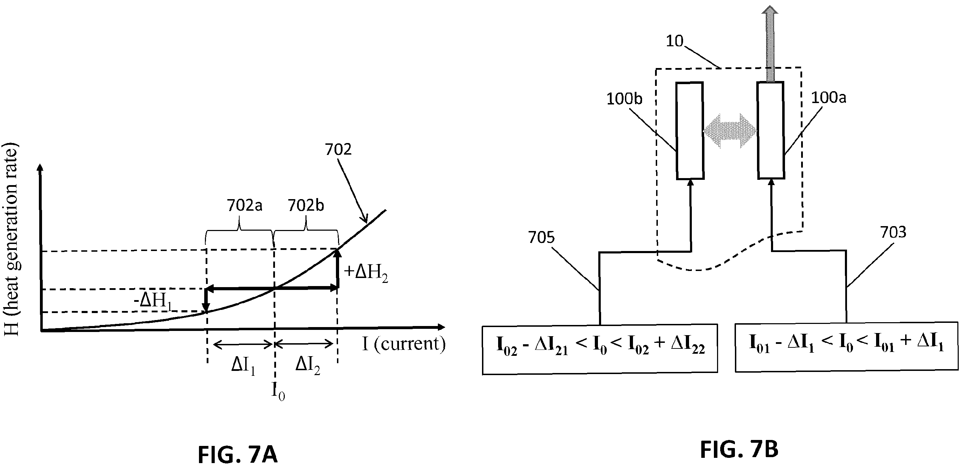

FIG. 7A schematically illustrates heat dissipation rate (dissipated thermal power) by an optoelectronic device, e.g., optoelectronic device 100a or 100b in apparatus 10 shown in FIG. 7B, or a thermoelectric device, as a function of the electrical current (I) provided to the optoelectronic device. The apparatus 10 and the optoelectronic devices 100a or 100b in FIG. 7B may comprise one of more features described above with respect to the apparatus 10 and the optoelectronic devices 100a or 100b in FIG. 1A, 1B, 2A and 2B. As described above with respect to FIGs 1A and 1B and shown in FIG. 7B, in some cases, an apparatus 10 may comprise a first optoelectronic device 100a optically connected to an output port 20 and a second optoelectronic device 100b in thermal communication with the first optoelectronic device 100a, and is configured to control (e.g., stabilize, reduce fluctuation, etc.) the temperature of one or more sections of the first optoelectronic device 100a. With reference to FIGs 1A and 1B, in some cases, the electrical signals 32a may be provided to the first optoelectronic device 100a to alter or control a characteristic of light generated by the first optoelectronic device 100a. For example, the electrical signals 32a may comprise a first electrical current 703 applied to one or more sections of the first optoelectronic device 100a, and the first electric current 703 may be modulated to generate a modulated output beam of light (e.g., amplitude modulated). In some other cases, the first current 703 applied to one or more sections of the first optoelectronic device 100a may be modulated or changed to modulate, change, or sweep, a wavelength of light output by the first optoelectronic device 100a. In some cases, changing or modulating the first electrical current provided 703 to a section the first optoelectronic device 100a induces a temperature change in that section and potentially other sections of the first optoelectronic device 100a. To reduce or potentially eliminate such temperature change, which can affect the operation of the first optoelectronic device 100a, the second electrical signals 32b provided to the first optoelectronic device 100a may be adjusted. In some cases, the second electrical signals 32b may comprise a second electrical current 705 provided to one or more sections of the second optoelectronic device 100b. The second electrical current 705 may be adjusted or modulated to reduce the temperature change in one or more sections of the first optoelectronic 100a by providing thermal compensation. For example, when a first current 703 provided to a first section of the first optoelectronic device 100a increases, a second electrical current provided to a second section of the second optoelectronic device 100b may be decreased to lower a temperature of second section with respect to the first section so at least a portion of heat generated in the first section flows to the second section. Similarly, when the first current 703 provided to a first section of the first optoelectronic device 100a decreases, a second electrical current 705 provided to a second section of the second optoelectronic device 100b may be increased to increase the temperature of second section with respect to the first section and to cause so heat flow from the second section to the first section. As a result, when the first current 703 is modulated or changed, the second electrical current 705 can stabilize the temperature of the first section by controlling the rate and direction of the thermal energy exchange between the first and the second sections.

As shown in FIG. 7A, the heat dissipation rate (H) by the optoelectronic device (or thermoelectric device) can be a nonlinear function of the current applied to the device (e.g., to a section of the optoelectronic device). In some examples, the heat dissipation rate can be expressed as I²×R, where R can be a resistance or effective resistance of the optoelectronic device or a resistance of a section of the optoelectronic device to which the electrical current is provided. In some cases, the electric current provided to an optoelectronic device may comprise a time varying electrical current configured to modulate optical power generated by a functional optoelectronic device configured to generate light (e.g., the first optoelectronic device 100a), or the electric current provided to a heat compensating electronic device (e.g., the second optoelectronic device 100b) to offset or balance heat generation by the functional optoelectronic device and stabilize its temperature. In some examples, the time varying current may change (e.g., oscillate) between I₀-|ΔI₁| and I₀+|ΔI₂|, where I₀ is a bias current (also referred to as a bias point) and ΔI₁ and ΔI₂ are positive and negative electric current variation magnitudes with respect to the bias current. In some cases, |ΔI₁| can be equal or substantially equal to |ΔI₂|. Due to the nonlinearity of the heat dissipation process, for a given bias current I₀, a change in heat dissipation rate can depend on whether the electric current increases or decreases. Given the nonlinear dependence of heat dissipation on the current provided to a device or a section of a device (as shown in FIG. 7A), to stabilize the temperature of the first section, a magnitude of the second electrical current 705 provided to the second optoelectronic device may be adjusted not only based on the amplitude of the change made to the first current 703 but also based on a first bias current (I₀₁) around which the first current is changed or modulated.

FIG. 7A shows when |ΔI₁| = |ΔI₂| = ΔI, an increase in heat generation rate (ΔH₂) in response to changing the electrical current from I₀ to I₀+ΔI can be different from (e.g., larger than) a reduction of the heat generation rate (ΔH₁) in response to changing the current from I₀ to I₀-ΔI. The difference between ΔH₁ and ΔH₂ is caused by a difference between the slope (or an average slope) of a first portion 702a of the curve 702 corresponding to I < I₀ and/or ΔI₁<0, and the slope of a second portion 702b of the curve 702 corresponding to I > I₀ and/or ΔI₂>0. As such, in some cases, the electric current provided to the heat compensating device may be modulated or adjusted asymmetrically with respect to a bias current in order to increase and decrease the amount of heat generated by the heat compensating device by the same amount or magnitude. More generally, a signal provided to the heat compensating device may be adjusted or modulated non-symmetrically with respect to a bias point and according to a heat generation characteristic and thereby a current-voltage characteristic of the heat compensating device. In some cases, a resistance (e.g., a current or voltage dependent effective resistance) of the heat compensating device may be determined using a measured current-voltage characteristic of the heat compensating device and the resistance may be used to determine the dependence of heat generation rate (H) as a function of electric current (or voltage) provided to the heat compensating device. Next a bias point (e.g., bias current) is selected and a variation (e.g., an asymmetric variation) of the current provided to the heat compensating device with respect to bias point may be determined based on the determined relation between heat generation and electric current.

With reference to FIG. 7B, in some examples, the first and second optoelectronic devices 100a, 100b, can be substantially identical devices with identical or substantially similar dimensions and/or current-voltage (IV) characteristics. In some cases, for example, the dimensions may be different by no more than 20%, 15%, 10%, 5%, 1%, 0.5%, 0.1% or any range formed by any of these values or possible larger or smaller. In some cases, the the first and second optoelectronic devices 100a, 100b, may receive identical or substantially identical bias currents (I₀) during the operation of apparatus 10. In some examples, the first optoelectronic device 100a may comprise a first optical cavity formed between a first front mirror and a first back mirror, and the second optoelectronic device 100b may comprise a second optical cavity formed between a second front mirror and a second back mirror, wherein dimensions of the first optical cavity. In some cases, the first front mirror, and the first back mirror are identical to those of the second optical cavity, the second front mirror, and the second back mirror or the dimensions may be different by no more than 20%, 15%, 10%, 5%, 1%, 0.5%, 0.1% or any range formed by any of these values or possible larger or smaller. The optical cavity may comprise a first gain section and/or a first phase section, and the second optical cavity may comprise a second gain section and/or a second phase section. In some cases the dimensions (e.g., a thickness, a length, a width, or any combination thereof) of the first phase section and the first gain section can be identical to those of the second phase section and the second gain section or the dimensions may be different by no more than 20%, 15%, 10%, 5%, 1%, 0.5%, 0.1% or any range formed by any of these values or possible larger or smaller.

In these examples, the temperature variations generated by modulating the first current 703 provided to the first optoelectronic device 100a, around I₀, may not efficiently be compensated by providing a second electrical current 705 having an opposite sign but otherwise equal to the first current 703, to the second optoelectronic device 100b. Given the nonlinearity of heat generation rate with respect to current, providing a second electrical current 705 that is just a phase shifted copy of the first electric current (e.g., by 180 degrees), to the second optoelectronic device 100b, may not result in temporal variation of heat dissipation shown in FIG. 4 where the combined average heat from the two sections remains constant. As such, to balance the heat generated by the first optoelectronic device 100a, the second electrical current 705 provided to the second optoelectronic device 100b may be adjusted taking into account the nonlinearity of heat generation rate with respect to the second electric current 705.

In some implementations, the electrical circuitry 30 that provides the first and second electrical signals 32a, 32b, to the first and second optoelectronic devices 100a, 100b, may be configured to adjust the second electrical signals 32b, based at least in part on the first electrical signals 32a. In some examples, the electrical circuitry 30 may adjust a property or characteristic of the second electrical current 705 based on a property or characteristic of the first electrical current 703. The property or the characteristic may include a rate of change, a peak value, a phase, an amplitude, and the like. For example, an amplitude of the second electrical current 705 may be changed before the first electrical current 703 is changed, and with a rate larger than those of the first electrical current 703, by a specified amount, where a time difference between the respective changes is also specified. In some cases, the electrical circuitry 30 may adjust the second electrical current 705 based on the first electrical signals 32a (e.g., the current 703, a voltage, etc.), taking into account the nonlinearity of heat generation rate by the second optoelectronic device 100b with respect to the second electrical current 705. In some implementations, the first and the second optoelectronic devices 100a, 100b, may have different designs, dimensions, structural characteristics, and/or material properties. In some other implementations, the second optoelectronic device 100b may be replaced by a thermoelectric device that is not capable of generating light. In these implementations, a bias or average value of the second electrical current 705 can be different from those of the first electrical current 703, however still the second electrical current 705 may be adjusted based at least in part on the nonlinear dependence of heat generation rate by the thermoelectric device on the second electrical current 705.

In various implementations, the second electrical signals 32b (e.g., the second electrical current 705) can be configured to operate the second optoelectronic device 100b (or a thermoelectric device in thermal communication with the first optoelectronic device 100a), such that a temperature or an average temperature of the first optoelectronic device 100a or at least a section of the first optoelectronic device 100a, does not change more than 1%, 3%, 5%, or 10%. In some examples, when the first electrical signals 32a are periodic, the average temperature can be determined over one or more periods of the first electrical signals 32a. In some other examples, the average temperature may be determined over a time period during which the first electrical signals 32a are adjusted to control, change, modulate, or sweep a characteristic of light generated by the first optoelectronic device 100a.

In some examples, the current-voltage (IV) characteristics of the first and the second optoelectronic devices 100a, 100b (or a thermoelectric device used for thermal compensation), may be individually measured to fully characterize their heat generation rate as a function of the electrical current received.

In some cases, the measured IV curve of an optoelectronic device (or a thermo-electric device) may be used to determine a resistance (R) of the optoelectronic device (or the thermo-electric device) as a function of voltage (or current) applied to the device. For example, a voltage (V) applied to the optoelectronic device (or the thermoelectric device) may be varied within a given range and a current (I) passing through the optoelectronic device (or the thermoelectric device) may be measured at different voltage values to calculate R=V/I for different values or V and corresponding I. In some cases, the resistive heat generation rate or thermal power generated by the optoelectronic device may be estimated as I² × R based on measured variation of R as a function of I. In some cases, where the device comprises a pn junction, the resistive heat generation rate or thermal power generated by the optoelectronic device may be estimated as I² × R + V_{d}× I based on measured variation of R as a function of I, where V_{d} is the diode voltage of the pn junction.

Once R and/or heat generation rate of a light generating optoelectronic device and/or the corresponding heat compensating optoelectronic (or thermoelectric) device are fully characterized, the second electrical current 705 provided to the heat compensating optoelectronic device 100b (or electronic device), can be determined based on a first current 703 provided to the first optoelectronic device 100a and the measured heat generation characteristics (e.g., R) for both devices. In some cases, an electronic circuit or control system (e.g., the electrical circuitry 30) that adjusts the electrical currents provided to the optoelectronic devices of apparatus 10 may be calibrated and/or programmed to determine and provide the second electrical current 705 to the second (heat compensating) optoelectronic device 100b based on a current provided to the first optoelectronic device and resistive or heat generation characteristics of the first and/or the second optoelectronic devices 100a, 100b.

In some examples, the current-voltage (IV) characteristics of individual sections of the first and/or the second and optoelectronic devices 100a, 100b (or a thermoelectric device used for thermal compensation), may be measured separately to fully characterize the heat generation characteristics (e.g., heat generation rate or R) as a function of the electrical current provided to these sections. In some cases, an individual section of an optoelectronic device (e.g., the first optoelectronic device 100a), may include a phase section, an optical amplifier section, optical gain section, a mirror, an optical absorber, or the like.

In some cases, the measured heat generation and/or resistive characteristics of the first and the second optoelectronic devices 100a. 100b, may be stored in a non-transitory memory of a control system (e.g., the electrical circuitry 30) and used by a control algorithm (e.g., current control algorithm) executed by the control system.

In some examples, an electrical circuitry (e.g., electric circuitry 30) that provides electric current 105 to a heat compensating device (e.g., the second optoelectronic device 100b) may be configured to adjust a signal property of the electrical signal provided to the heat compensating device non-symmetrically based at least in part on the current-voltage characteristic of the heat compensating device. In some examples, the electrical circuitry may adjust a signal property of the second electrical signal non-symmetrically with respect to a bias point in a manner consistent with a nonlinearity of a resistance or a current of the heat compensating device, or a nonlinearity in a heat generation rate of the heat compensating device.

### Temporal current control for fast and stable heat compensation

The heat transfer between the second optoelectronic device 100b (or an electronic heat compensating device), is not instant; as a result, there can be delay between changing the second electrical current 705 provided to the second optoelectronic device 100b and its impact on the temperature of one or more sections of the first optoelectronic device 100a. For example, when the first electrical signals 32a (e.g., the first electrical current 703), provided to one or more sections of the first optoelectronic device 100a are increased (or decreased) starting as a time tₛ, decreasing (or increasing) the second electrical current 705 provided to the second optoelectronic device 100b (e.g., to a corresponding section of the second optoelectronic device 100b) at the same time tₛ may not keep the temperature of the corresponding sections of the first optoelectronic device 100a substantially constant or within a desired range at least during a delay (or thermal response) period tₛ- tᵣ, where tᵣ is the time at which the change made to the second electrical current 705 thermally affects the first optoelectronic device 100a. In some cases, a change in the temperature of one or more sections of the optoelectronic device 100a can be nonlinear with respect to a change in the second current 705. In some cases, a change in the rate of heat transfer rate between the optoelectronic device 100a and the optoelectronic device 100b (or another heat compensating device) can be nonlinear with respect to a change in the second current 705.

In some implementations, the electrical circuitry 30 may control the first electrical current 703 (or one of the first signals 32a) and the second electrical current 705 such that a time (t₂) at which the second electrical current 705 is changed, lags behind or leads the time ti at which the first electrical current 703 undergoes a change or discontinuity. In some cases, the change or the discontinuity of the first electrical current 703 can be associated to a rate of change larger than a threshold value. In various implementations, |t₁-t₂| can be from 10 to 20 nanoseconds, 20 to 100 nanoseconds, from 100 nanoseconds to 1 microsecond, from 1 to 100 microseconds, from 100 microseconds to 1 millisecond, from 1 to 10 milliseconds or any range formed by these values or larger or smaller values. In some cases, |t₁-t₂| may be determined based on the geometries of the first and second optoelectronic devices 100a/100b, a rate of change of the first electric current 703, and/or a period (or frequency) of the first electrical current 703, or any combination of these parameters.

Additionally or alternatively, in some implementations, the electrical circuitry 30 may control the second electrical current 705 such that an initial slope (rate of change) of the second electrical current 705 is sufficiently large to reduce or maintain a delay between the change made to the second electrical current 705 and the resulting change in the temperature of at least a section of the first optoelectronic device 100a, below a threshold delay value. In some cases, the threshold delay value can be from 10 to 20 nanoseconds, 20 to 100 nanoseconds, from 100 nanoseconds to 1 microsecond, from 1 to 100 microseconds, from 100 microseconds to 1 millisecond, from 1 to 10 milliseconds or any range formed by these values or larger or smaller values. In some cases, the threshold delay may be determined based on the geometries of the first and second optoelectronic devices 100a/100b, a rate of change of the first electrical current 703, or a period (or frequency) of the first electrical current 703, or any combination of these parameters.

In some cases, the second electrical current 705 provided to the second optoelectronic device 100b device may be pre-emphasized or post-emphasized with respect to a change made to the first electrical signals 32a to increase a rate of heat transfer between the first and the second optoelectronic devices 100a and 100b and thereby the speed by which a thermal equilibrium is reached between the first and the second optoelectronic devices 100a and 100b, or the temperature of the first optoelectronic device 100b is stabilized. In various implementations, a pre-emphasized or post-emphasized current may include a deviation of timing, magnitude, temporal behavior, or any combination of these, of the second electrical current 705, from a timing, magnitude, or temporal behavior of the first electrical current 703. In some cases, a pre-emphasized or post-emphasized current may include a deviation of timing, magnitude, temporal behavior, or any combination of these, of the second electrical current 705, from a monotonous (e.g., linear) change from an initial value to a final value.

In some cases, variations of a stabilized temperature may not exceed a temperature uncertainty limit. In some cases, the temperature uncertainty limit can be an upper bound for temperature fluctuations (or variations) of the light generating optoelectronic device (e.g., the first optoelectronic device 100a) or a section of the light generating optoelectronic device. In various implementations, the temperature uncertainty limit can be from 0.0001 to 0.0005 degrees, from 0.0005 to 0.001 degrees, from 0.001 to 0.005 degrees, from 0.005 to 0.01 degrees, from 0.01 to 0.05 degrees, from 0.05 to 0.1 degrees, or any range formed by these values or larger or smaller values. The temperature uncertainty limit for an optoelectronic device or an apparatus may comprise a specified value or range determined based on an application of the optoelectronic device or the apparatus. For example, when light generated by the optoelectronic device is provided to another optical system or device, the temperature uncertainty limit for the optoelectronic device may be determined based on sensitivity of the other optical device or the optical system on wavelength and/or power of light received from the optoelectronic device. In some cases, a temperature uncertainty limit may be determined based on a specified wavelength uncertainty limit for an application. In some examples, the specified wavelength uncertainty limit can be smaller than 10⁻⁷, smaller than 10⁻⁶, smaller than 10⁻⁴, or smaller than 1% of a wavelength (e.g., a center wavelength) of light generated by the optoelectronic device.

In some cases, a signal provided to one or more sections of the second optoelectronic device 100b (the heat compensating device) may be adjusted such that the temperature of one or more sections of the first optoelectronic device 100a remain within ± 0.0001, ± 0.001%, ± 0.01%, ± 0.1% ± 1%, ± 2%, ± 3%, ± 4%, ± 5%, ± 6%, ± 7%, ± 8%, ± 10% or ± 20% of a specified temperature, or any range between any of these values.

In some cases, a signal provided to one or more sections of the second optoelectronic device 100b (the heat compensating device) may be adjusted such that the temperature of one or more sections of the first optoelectronic device 100a remain within ± 10⁻⁶ °C, ± 10⁻⁵ °C, ± ± 10⁻⁴ °C, ± 10⁻³ °C, ± 10⁻² °C, or ± 10⁻¹ °C, or any range between any of these values, from a specified temperature.

In some cases, a signal provided to one or more sections of the second optoelectronic device 100b (the heat compensating device) may be adjusted to stabilize the wavelength (e.g., center wavelength) of light generated by the first optoelectronic device near a target wavelength. In some cases, the target wavelength can be a time dependent and temporally change according to a predefined temporal profile. In some cases, stabilizing or tuning the wavelength (e.g., center wavelength) of light generated by the first optoelectronic device comprises maintaining the wavelength within ± 0.00001%, within ± 0.0001%, within ± 0.001%, within ± 0.01%, within ± 0.1%, within ± 1%, within ± 2%, within ± 3%, within ± 4%, within ± 5% of the target wavelength, or any range between any of these values. In some cases, stabilizing or tuning the wavelength (e.g., center wavelength) of light generated by the first optoelectronic device comprises maintaining the wavelength within ± 10⁻² picometer, within ± 10⁻¹ picometer, within ± 1 picometer, within ± 10 picometers, within ± 100 picometers, within ± 1 nanometer from a target wavelength or any range between any of these values. In some cases, the target wavelength may comprise wavelengths around 850 nm, 980 nm, 1300 nm, or 1550 nm.

With continued reference to FIG. 7B, in some cases, when a change is made to the second electrical current 705 in response to a change in the first electrical current 703, an amplitude of a pre-emphasized (or post emphasized) second electrical current 705 may comprise a local maximum or a local minimum, following the change made to the second electrical current 705. The local maximum may comprise an overshoot and the local minimum may comprise an undershoot with respect to the first electrical current 703. For example, a pre-emphasized (or post emphasized) second electrical current 705 may comprise an increase or decrease such as a progressive increase or decrease or a monotonic increase or decrease or growth (e.g., linear growth) from an initial value followed by a local maximum and a decay to a later value. A pre-emphasized second electrical current 705 may comprise a local maximum (or local minimum) prior to a variation of the first current 703, and post-emphasized second electrical current 705 may comprise a local maximum (or local minimum) after a variation of the first current 703 (or first signals 32a).

In various implementations, a delay between the local maximum (or local minimum) of the second electrical current 705 and a local maximum (or local minimum) of the first electrical current 703 can be from 1 to 10 nanoseconds, from 10 to 100 nanoseconds, from 100 nanoseconds to 1 microseconds, from 1 to 10 microseconds, from 10 to 1 milliseconds, or any range formed by these values or larger or smaller values.

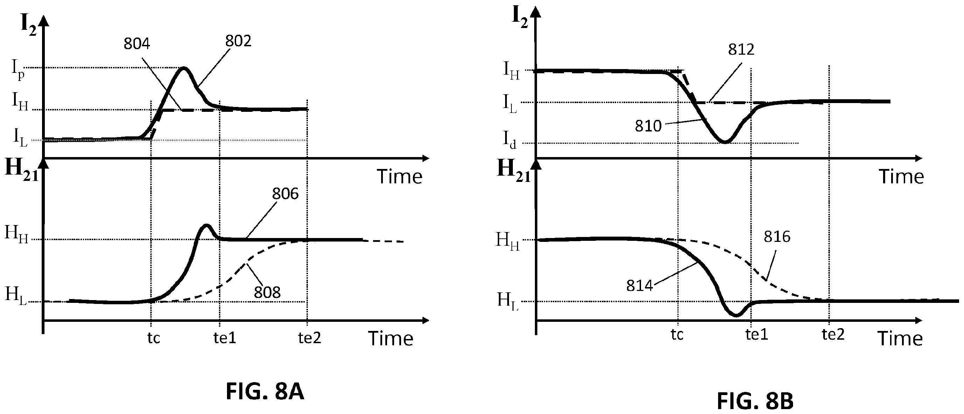

Figures 8A-8B schematically illustrate two example temporal variations of the electrical current (I₂) 802, 804, provided to a heat compensating device (e.g., the second optoelectronic device 100b) and the resulting changes in the heat transfer rate (H₂₁) 806, 808, from the heat compensating device to a light generating optoelectronic device (e.g., the first optoelectronic device 100a). In some cases, the electrical current 804 can be a modified electrical current with respect to the electrical current 802 and results in faster thermal control of the light generating optoelectronic device. Figures 8A and 8B respectively show, (A) the electrical current is increased to provide heat to the light generating optoelectronic device and (B) the electrical current is reduced to absorb heat from the light generating optoelectronic device. The solid and dashed lines represent heat transfer rate variations and the respective electrical currents corresponding to faster and delayed thermal control respectively.

In the example shown in FIG. 8A it is assumed that the temperature of at least a section of an optoelectronic device (e.g., the first optoelectronic device 100a) is decreasing so thermal energy flows from the heat compensating device to the optoelectronic device. As such the electrical current I² (e.g., the second electrical current 705) is increased from a lower initial value I_{L} to a higher final value I_{H}, e.g., to establish or increase heat flow (H₂₁) from the heat compensating device (e.g., the second optoelectronic device 110b) to the corresponding section of the optoelectronic device. As a result, the rate of thermal energy transfer (H₂₁) from the heat compensating device to the optoelectronic device increases from a lower value H_{L}, corresponding to an initial thermal equilibrium, to a higher value H_{H} corresponding to a new thermal equilibrium between the heat compensating device and the optoelectronic device. In the example shown, the modified electrical current I² 802 (solid line) includes an overshoot when transitioning from the lower value I_{L} to the higher value I_{H}, while the electrical current I₂ 804 increases monotonously (e.g., linearly) from the lower value I_{L} to the higher value I_{H}. In some examples, a difference between a peak value (Iₚ) of the modified electrical current I₂ 802 and the lower value I_{L} can be larger than a difference between the higher value I_{H} and the lower value I_{L}, by a factor from 1.2 to 1.5, 1.5 to 2, 2 to 4, 4 to 6, 6 to 8, 8 to 10 , 10 to 50, or any range formed by these values or larger or smaller values. The thermal energy transfer (H₂₁) 806 resulting from the modified electrical current I₂ 802 changes from the lower value H_{L} to the higher value H_{H} in a time period (t_{c}-tₑ₁), which is shorter than a time period (tₑ₂-t_{c}) required for the thermal energy transfer (H₂₁) 808, resulting from the electrical current I₂ 804, to change from the lower value H_{L} to the higher value H_{H}.

As shown in the bottom panel, the modified electrical current I₂ 802 (solid line), can stabilize thermal energy transfer (H₂₁) 806, and thereby the temperature of the optoelectronic device, faster than the electrical current I₂ 804 (dashed line). In some cases, an overshoot of the second electrical current may result in an overall faster temperature compensation without causing an overshoot of the first electrical current.

In the example shown in FIG. 8B it is assumed that the temperature of at least a section of an optoelectronic device (e.g., the first optoelectronic device 100a) is increasing so thermal energy has to flow from the optoelectronic device to the heat compensating device. As such, the electrical current I₂ (e.g., the second electrical current 705) is decreased from a higher value I_{H} to a lower value I_{L} to decrease heat flow (H₂₁) from the heat compensating device to the corresponding section of the optoelectronic device. As such, the rate of thermal energy transfer (H₂₁) from the heat compensating device to the optoelectronic device is decreased from an initial higher value H_{H}, corresponding to an initial thermal equilibrium, to a final lower value H_{L} corresponding to a new thermal equilibrium between the heat compensating device and the optoelectronic device. The electrical current I₂ 810 (solid line), that includes an undershoot between the higher and lower values I_{H} and I_{L}, can stabilize the temperature of the optoelectronic device faster than the electrical current I₂ 812 (dashed line), that is decreases monotonously (e.g., linearly) from the higher I_{H} value to the lower value I_{L}. In some examples, the absolute value of a difference between a minimum (I_{d}) of the modified electrical current I₂ 810 and the lower value I_{L} can be larger than a difference between the higher value I_{H} and the lower value I_{L}, by a factor from 1.2 to 1.5, 1.5 to 2, 2 to 4, 4 to 6, 6 to 8, 8 to 10, 10 to 50, or any range formed by these values or larger or smaller values.

FIGs. 8A and 8B show that while both electrical currents 802, 804 (or 812 and 810) are changed substantially at the same time (t_{c}), the overshoot (or undershoot) in the electrical current 802 (or 810) causes the heat transfer rate to reach the final value H_{H} (or H_{L}) faster and thereby stabilizes the temperature of the optoelectronic device in a shorter period. In some examples, the delay between the time tₑ₂ and tₑ₁ at which the new thermal equilibrium is established by the electrical current 802 (or 810) and the electrical current 804 (or 802) respectively, may depend on the magnitude of the local maximum Iₚ (or local minimum I_{d}) of the electrical current 802 (or 810) and the slopes of the electrical current 804 (812) and the electrical current 802 (810) during a growth or decay period. In some cases, the time t_{c} at which a change to I₂ 705 is initiated may be determined based on a time at which a change is made to the first current 703. For example, t_{c} can be before the time at which the change is made to the first current 703.

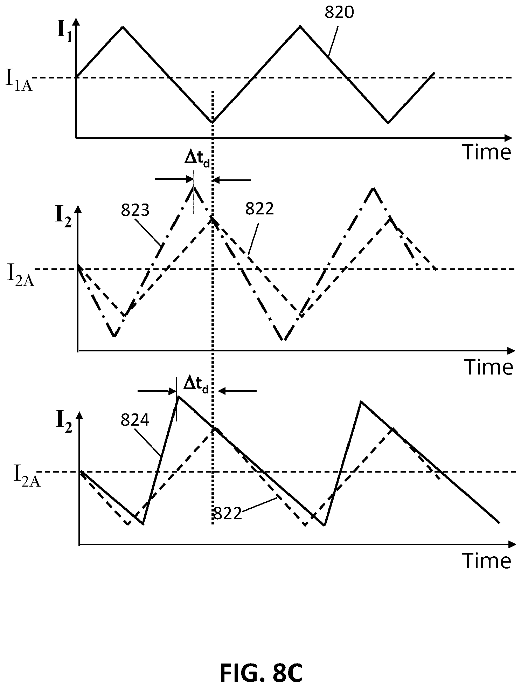

FIGs. 8C shows an example temporal variation of the electric current I₁ 820 (e.g., electric current 703) provided to a section of the first optoelectronic device 100a and two example temporal variations of a modified electric current (I₂) 823, 824 (e.g., electric current 705) provided to a section of the second optoelectronic device 100b (e.g., the heat compensating device) to stabilize the temperature of the first optoelectronic device 100a. In some cases, the modified electric current (I₂) 823, 824, can be a pre-emphasized electric current. In the example shown electric current I₁ 820 comprises a periodic triangular wave having identical (or nearly identical) positive and negative slopes and a symmetric amplitude variation with respect to an average electric current I_{1A}. In some cases, an electric current I₂ 822 (dashed line) that is 180 degrees phase shifted with respect to the current I₁ 820 but has a temporal variation substantially identical to that of the electric current I₁ 820, may be provided to the second optoelectronic device 100b, to stabilize the temperature of the first optoelectronic device 100a. In some examples, where the first and the second optoelectronic devices are substantially identical devices, the electrical current I₁ 820 and I₂ 822 can have substantially equal amplitudes. In some cases, the electric current I₂ 822 may not compensate for the temperature variation of the first optoelectronic device 100a with sufficient speed and/or efficiency and result in residual temperature variations of the first optoelectronic device 100a. In some implementations, providing a modified electric current (e.g., a pre-emphasized electric current) I₂ may improve the heat compensation speed and efficiency and thereby reduce the residual temperature variations of the first optoelectronic device 100a. In some examples, a modified electric current I₂ 823 can be a pre-emphasized electric current I₂ 823 (dashed-dotted line) that has a temporal profile substantially similar to that of the electric current I₂ 822 but a local maximum of the pre-emphasized electric current 823 is delayed (Δt_{d}) relative to a respective local maximum of the electric current I₂ 822. In some such examples, a pre-emphasized electric current I₂ 823 may have a larger amplitude than the electric current I₂ 822. In some examples, a modified electric current I₂ can have a different temporal profile compared to the electric current I₂ 822. For examples, with reference to electric current I₂ 822, a modified electric current I₂ can be a pre-emphasized electric current I₂ 824 (solid line) having an asymmetric (e.g., saw tooth) temporal profile that is delayed with respect to the electric current I₂ 822.

In various implementations, the delay (Δt_{d}) between a peak of the pre-emphasized electric current I₂ 823 (or 824) and a corresponding dip (local minimum) and/or onset of stead state of the electric current I1 820 can be from 1 to 10 nanoseconds, from 10 to 100 nanoseconds, from 100 nanoseconds to 1 microseconds, from 1 to 10 microseconds, from 10 to 1 milliseconds, or any range formed by these values or larger or smaller values.

In some cases, the absolute value of a local maximum of the electrical signal (e.g., the modified electric current I₂ 823, 824, or electric current 705) provided to a section of the heat compensating device (e.g., the second optoelectronic device 100b), can be larger than the absolute value of the local minimum of the electrical signal (e.g., electric current I₁ 820 or electric current 703) provided to the light generating optoelectronic device (e.g., the first optoelectronic device 100a).

In some cases, the absolute value of a local minimum of the electrical signal (e.g., the modified electric current I₂ 823, 824, or electric current 705) provided to a section of the heat compensating device (e.g., the second optoelectronic device 100b), can be larger than the absolute value of the local maximum of the electrical signal (e.g., electric current I₁ 820 or electric current 703) provided to the light generating optoelectronic device (e.g., the first optoelectronic device 100a).

In some cases, during a transitionary period when the second electrical current 705 provided to the heat compensating device is changed from a lower value to higher value (from a higher value to a lower value), the second electrical current 705 may be distorted compared to the first electrical current 703, to increase a speed by which a thermal equilibrium is reached between the first and the second optoelectronic devices 100a and 100b, or the temperature of the first optoelectronic device 100a is stabilized. The distortion may include any linear, nonlinear, discontinuous, stepwise behavior different from a continues and monotonous change from an initial value to a final value. In some examples, the distorted second electrical current 705 may increase such speed by increasing a rate of heat transfer between the first and the second optoelectronic devices 100a and 100b.

In some cases, the transitionary period may overlap, precede, or succeed a period during which the first electrical signals 32a (e.g., the electrical current 703) are changed. A distorted current may comprise one or more inflection points, one or more local maximums, one or more local minimums, or other features.

The characteristics of a pre or post emphasized electrical current, or signal provided to the heat compensating device may be determined based on a response time quantifying a delay between a change made to the second current 705 provided to the heat compensating device (e.g., the second optoelectronic device 100b) and the resulting temperature change in the optoelectronic device (e.g., the first optoelectronic device 100a).

The response time may depend on structural and geometrical properties of the optoelectronic and the heat compensating device, the substrate (or chip) on which these devices are fabricated, a distance between the two devices and the like. For example, the response time may depend on the thickness of the substrate, location of a p-type layer (p-side) of one or both devices with respect to the substrate (e.g., p-side down or p-side up mounted), a lateral distance between the two devices, electrical and thermal impedances of the devices, thermal mass of electrical contacts used to provide signals (e.g., currents) to these devices, and the like.

In some implementations, the characteristics of a signal provided to a heat compensating device and its timing with respect to a change made to a signal provided to the optoelectronic device thermally controlled by the heat compensating device, may be determined using a calibration process. In some cases, an electrical circuitry that controls the signals provided to compensating device (e.g., the electrical circuitry 30), can be calibrated, adjusted, or programed and/or configured according to the determined characteristics. In some implementations, a circuit parameter of the electrical circuitry may be adjusted according to the determined characteristics. In various implementations, a circuit parameter may comprise a parameter of a circuit component (e.g., a resistance of a variable resistor, a gain of an amplifier, a voltage provided to a component, a value of a logic gate, state of a switch, an attenuation of a variable attenuator, and the like), a parameter stored in a non-transitory memory of the electrical circuitry, or a parameter in an algorithm used by the electrical circuitry to control the one or more signals provided to the heat compensating device.

In some cases, the calibration process may comprise changing a first signal provided to the optoelectronic device and adjusting a second signal provided to the heat compensating device while monitoring the wavelength of light generated by the optoelectronic device. In some cases, the wavelength of the optoelectronic device may be monitored using a wave meter, an oscilloscope, a system comprising an etalon, a grating, a Mach-Zehnder interferometer, or other frequency/wavelength selective devices and one or more photodetectors (e.g., photodiodes) configured to generate detection signals upon receiving optical power. In some cases, a wavelength selective optical device may comprise an optical interferometer or an optical filter.

In some cases, adjusting the second signal may comprise, pre-emphasizing, post-emphasizing, or otherwise distorting the second signal during a transitionary period. Additionally, adjusting the second signal may comprise adjusting a temporal alignment between the transitionary period and a period during which the first signal is changed. Changing the first signal may comprise modulating the amplitude of a current or voltage provided to at least a section of the optoelectronic device. In some examples, the second signal may be adjusted to maintain the wavelength of light generated by the optoelectronic device substantially constant or within a wavelength uncertainty limit centered at a target wavelength. In some cases, wavelength uncertainty limit can be less than 10⁻⁷, less than 10⁻⁶, less than 10⁻⁵, less than 10⁻⁴, less than 10⁻³, less than 1%, less than 5%, or less than 10%, times the wavelength (e.g., a center wavelength) of light generated by the optoelectronic device (e.g., the first optoelectronic device 100a). In some cases, wavelength uncertainty limit can be from 10⁻² picometers to 10⁻¹ picometers, from 10⁻¹ picometers to 1 picometers, from 1 picometer to 10 picometers, from 10 picometers to 100 picometers or any range formed by these values or larger or smaller values.

In some examples, the second signal may be adjusted to maintain the optical power of light generated by the optoelectronic device substantially constant or within a power uncertainty limit. In some cases, the power uncertainty limit can be less than 10⁻⁵, 10⁻⁴, less than 10⁻³, less than 1%, less than 5%, or less than 10%, times a target optical power.

In some examples, the second signal may be adjusted to increase a speed of thermal control (e.g., reducing the response time), or improve the stability of temperature of the optoelectronic device.

In some implementations, the thermal control of a section of the optoelectronic device may be affected by a thermal response time of the corresponding heat compensating device (e.g., an optoelectronic device or a thermoelectric device). As such in these implementations, the amplitude of the electric current provided to the heat compensating device, and its temporal alignment with respect to an electric current provided to the optoelectronic device may be determined based at least in part on the response time of the heat compensating device.

In some implementations, the electrical circuitry 30 may be programed or configured to provide or tailor a temporal profile and/or amplitude of the second electronic signals 32b provided to a section of the second optoelectronic device 100b (or a thermoelectric signal) according to methods and modified electric currents described above with respect to FIG. 8A-8C.

With reference to FIG. 1A-1B, in some implementations, the electrical circuitry 30 may be programed or configured to control the first electronic signals 32a provided to a section of the first optoelectronic device 100a to compensate for residual temperature variations that are not compensated by the heat compensating device (e.g., the second optoelectronic device 100b). For example, in addition to controlling the second electronic signals 32b, the electrical circuitry 30 may control a bias current provided to a section of the first optoelectronic device 100a to further stabilize a temperature of the section and thereby the optical output power, polarization, or the wavelength (e.g., the center wavelength) of the first optoelectronic device 100a. In some cases, the electrical circuitry 30 may control a current (e.g., a bias current) provided to a section of the first optoelectronic device 100a to fine tune a wavelength of light generated by the first optoelectronic device 100a.

In some examples, during a factory calibration process the electrical circuitry 30 may be programed or configured to provide second electronic signals 32b having tailored amplitude and temporal profiles, to the second optoelectronic device 100b (or a thermoelectric signal), and a user may further configure or program the electrical circuitry 30, to adjust first electronic signals 32a provided to first optoelectronic device 100a to compensate for a residual temperature variation of the first optoelectronic device 100b (that is not compensated by the heat compensating device). In some such examples, the adjustment of the first electronic signals 32a may comprise adjusting one or more bias current provided to the one or more sections of the first optoelectronic device 100a.

In various implementations, the electrical circuitry 30 may comprise a digital circuit, an analog circuit, or combination thereof. As such a factory calibration process or user post-calibration adjustment may comprise, adjusting one or more tunable electronic components in a digital or analog circuits, modifying machine executable commands executed by a processor of the electrical circuitry 30, or adjusting a parameter of an algorithm executed by a processor of the electrical circuitry 30.

In some examples, the electrical circuitry 30 may use an empirical model for controlling the first and second electronic signals 32a and 32b (e.g., the electric currents 703 and 705). In some such examples, the empirical model may be implemented as an algorithm and a set of parameters stored in a memory of the electrical circuitry 30 and executed by a processor of the electrical circuitry 30. In some cases, the value of at least a subset of parameters may be adjusted during a factory calibration process or determined based on calculated or experimental data.

In various implementations, pre/post-emphasis of a signal provided to the heat compensating device with overshoot or undershoot can be used to increase the speed at which a thermal equilibrium between the heat compensating device and the light generating optoelectronic device.

In some examples, the heat compensating device may comprise one or more heating elements (e.g., resistive pads, heat generating pads).

In various implementations, pre/post-emphasis can include timing, magnitude, and shape (e.g., specific temporal profile) of the signal provided to the heat compensating device.

In some cases, temporal profile, amplitude, timing, or other characteristics of a pre/post-emphasized signal (e.g., electrical current) may be determined based at least in part on a dimension, design, material property, electric impedance, and/or thermal impedance, of the heat compensating and the light generating device. In some cases, temporal profile, amplitude, timing, or other characteristics of a pre/post-emphasized signal (e.g., electrical current) may be determined based at least in part on a relative position of the heat compensating and the light generating device. Further temporal profile, amplitude, timing, or other characteristics of a pre/post-emphasized signal (e.g., electrical current) may be determined based on a thickness of a substrate (e.g., a chip) on which the heat compensating device and the light generating device are fabricated and/or an orientation of the heat compensating and the light generating device with respect to the substrate (e.g., p-side up or p-side down mounted).

In some cases, temporal profile, amplitude, timing, or other characteristics of a pre/post-emphasized signal (e.g., electrical current) provided to the heat compensating device , and/or a delay between the pre/post-emphasized signal and a signal provided to the light generating device may be determined based at least in part thermal mass of contact pad (e.g., amount metal deposited on a section of the heat compensating or light generating device), and/or a response time of the circuit that controls the pre/post-emphasized signal (e.g., a loop time constant such as TEC loop constant)

In some implementation, in addition to heat compensation by an adjacent device, a signal provided to the light generating device (e.g., a bias current) may adjusted, modulated, or controlled to compensate for variation of a property of light output by the light generating device (e.g., wavelength or modulation amplitude).

### Example embodiments

Various additional example embodiments of the disclosure can be described by the following examples:
Group 1
   Example 1. An apparatus comprising:
      an optoelectronic device configured to generate optical signals;
      a heat compensating device in thermal communication with the optoelectronic device; and
      electrical circuitry configured to provide at least a first electrical signal to the optoelectronic device and at least a second electrical signal to the heat compensating device to controllably adjust a temperature of the optoelectronic device;
      wherein the electrical circuitry is further configured to adjust a signal property of the second electrical signal based at least in part on a signal property of the first electrical signal to reduce a delay between a change in the second electrical signal and a corresponding adjustment in the temperature of the optoelectronic device.
   Example 2. The apparatus of any of Examples above, wherein the signal property comprises an amplitude change, a rate of the amplitude change, a peak amplitude value, or a phase of the second electrical signal.
   Example 3. The apparatus of Example 2, wherein a rate of the amplitude change is larger in a portion of the second electrical signal compared to corresponding portion of the first electrical signal.
   Example 4. The apparatus of Example 2, wherein the second electrical signal is pre-emphasized or post-emphasized with respect to the first electrical signal.
   Example 5. The apparatus of Example 4, wherein the second electrical signal comprises an overshoot or an undershoot portion.
   Example 6. The apparatus of any of Examples above, wherein the first electrical signal comprises a periodic signal having a period and a local maximum of the second electrical signal lags a local minimum of the first electrical signal by an amount less than 50% of the period of the first electrical signal.
   Example 7. The apparatus of Example 6, wherein the absolute value of the local maximum of the second electrical signal is larger than the absolute value of the local minimum of the first electrical signal.
   Example 8. The apparatus of any of Examples above, wherein the first electrical signal comprises a periodic signal having a period and a local minimum of the second electrical signal leads a local maximum of the first electrical signal by an amount less than 50% of the period of the first electrical signal.
   Example 9. The apparatus of Example 8, wherein the absolute value of the local minimum of the second electrical signal is larger than the absolute value of the local maximum of the first electrical signal.
   Example 10. The apparatus of any of Examples above, wherein the first and the second electrical signals comprise periodic signals and a phase of the first electrical signal is shifted with respect to the second electrical signal by 180 degrees.
   Example 11. The apparatus of Example 9, wherein the second electrical signal is configured to operate the heat compensating device such that a difference between thermal energy generated and thermal energy dissipated by the optoelectronic device, averaged over a time interval, is less than a threshold value.
   Example 12. The apparatus of Example 11, wherein the threshold value is less than 5% of heat generated by the heat compensating device, averaged over the time interval.
   Example 13. The apparatus of Example 11, wherein the first electrical signal comprises a periodic signal having a period and the time interval comprises one or more of said period.
   Example 14. The apparatus of any of Examples above, wherein the electrical circuitry is further configured to adjust the signal property non-symmetrically based at least in part on the current-voltage characteristic of the heat compensating device.
   Example 15. The apparatus of Example 14, wherein the electrical circuitry is further configured to adjust a signal property of the second electrical signal non-symmetrically with respect to a bias point in a manner consistent with a nonlinearity of a resistance, a current of the heat compensating device, or a nonlinearity in a heat generation rate of the heat compensating device.
   Example 16. The apparatus of any of Examples above, wherein the heat compensating device comprises a second optoelectronic device.
   Example 17. The apparatus of Example 16, wherein the optoelectronic device and the second optoelectronic device are substantially identical.
   Example 18. The apparatus of Example 16, wherein the optoelectronic device comprises a first optical cavity formed between a first front mirror and a first back mirror, and the second optoelectronic device comprises a second optical cavity formed between a second front mirror and a second back mirror.
   Example 19. The apparatus of Example 18, wherein dimensions of the first optical cavity, the first front mirror, and the first back mirror are different from those of the second optical cavity, the second front mirror, and the second back mirror, respectively, by no more than 20%.
   Example 20. The apparatus of Example 18, wherein the first optical cavity comprises a first gain section and a first phase section, and the second optical cavity comprises a second gain section and a second phase section.
   Example 21. The apparatus of Example 20, wherein dimensions of the first phase section and the first gain section are different from those of the second phase section and the second gain section, respectively, by no more than 20%.
   Example 22. The apparatus of Example 16, wherein the first electrical signal is provided to a first section of the optoelectronic device and the second electrical signal is provided to a corresponding first section of the second optoelectronic device.
   Example 23. The apparatus of Example 22 wherein the electrical circuitry is further configured to provide a third electrical signal to a second section of the optoelectronic device and a fourth electrical signal to a corresponding second section the second optoelectronic device.
   Example 24. The apparatus of Example 23, wherein the electrical circuitry is configured to adjust a signal property of the fourth electrical signal based at least in part on a signal property of the third electrical signal.
   Example 25. The apparatus of Example 24, wherein the third electrical signal is a periodic signal having a period and a local maximum of the fourth electrical signal lags a local minimum of the third electrical signal by an amount less than 50% of the period of the first electrical signal.
   Example 26. The apparatus of Example 24, wherein the third electrical signal is a periodic signal having a period and a local minimum the fourth electrical signal lags a local maximum of the third electrical signal by an amount less than 50% of the period of the first electrical signal.
   Example 27. The apparatus of Example 16, wherein the optoelectronic device and second optoelectronic devices have the same design.
   Example 28. The apparatus of Example 16, wherein the optoelectronic device and second optoelectronic devices have different designs.
   Example 29. The apparatus of v, wherein the heat compensating device and the optoelectronic device are formed on a common substrate.
   Example 30. The apparatus of any of Examples above, wherein the optoelectronic device comprises a wavelength tunable laser.
   Example 31. The apparatus of any of Examples above, wherein the optoelectronic device comprises at least one optical reflector, at least one optical gain section, the at least one optical reflector comprising an optical grating.
   Example 32. The apparatus of Example 31, wherein the first electrical signal is provided to the at least one optical reflector of the optoelectronic device.
   Example 33. The apparatus of any of Examples above, wherein the electrical circuitry is further configured to adjust the second electrical signal based at least in part on the first electrical signal to maintain wavelength variations of the optical signals generated by the optoelectronic device within a wavelength uncertainty limit.
   Example 34. The apparatus of any of Examples above, wherein the heat compensating device is in thermal communication with the optoelectronic device via a common substrate on which both the heat compensating device and the optoelectronic device are fabricated.
   Example 35. The apparatus of any of Examples above, wherein the heat compensating device comprises a thermoelectric device.
   Example 36. The apparatus of Example 35, wherein the thermoelectric device comprises a resistor, or a thermoelectric cooler.
   Example 37. The apparatus of Example 35, wherein the thermoelectric device comprises a film resistor or semiconductor junction.
   Example 38. The apparatus of any of Examples above, wherein the electrical circuitry is configured to provide the first electrical signal to a wavelength control section of the optoelectronic device to control the wavelength of the optical signal.
   Example 39. The apparatus of Example 38, wherein the wavelength control section comprises a mirror or a phase section.
   Example 40. The apparatus of any of Examples above, wherein the electrical circuitry is configured to provide the first electrical signal to a gain section of the optoelectronic device to control the amplitude of the optical signal.
Group 2
   Example 1. An apparatus comprising:
      an optoelectronic device configured to generate optical signals;
      a heat compensating device in thermal communication with the optoelectronic device, said heat compensating device having a current-voltage characteristic; and
      electrical circuitry configured to provide at least a first electrical signal to the optoelectronic device and at least a second electrical signal to the heat compensating device to controllably adjust a temperature of the optoelectronic device;
      wherein the electrical circuitry is further configured to adjust a signal property of the second electrical signal non-symmetrically based at least in part on the current-voltage characteristic of the heat compensating device.
   Example 2. The apparatus of any of Examples above, wherein the electrical circuitry is further configured to adjust a signal property of the second electrical signal non-symmetrically with respect to a bias point in a manner consistent with a nonlinearity of a resistance or a current of the heat compensating device.
   Example 3. The apparatus of Example 2, wherein the electrical circuitry is configured to adjust the signal property of the second electrical signal non-symmetrically with respect to said bias point in a manner consistent with a nonlinearity in a heat generation rate of the heat compensating device.
   Example 4. The apparatus of any of Examples above, wherein the electrical circuitry is further configured to adjust the signal property of the second electrical signal based at least in part on a signal property of the first electrical signal in a manner so as to reduce a delay between a change in the second electrical signal and a corresponding adjustment in the temperature of the optoelectronic device.
   Example 5. The apparatus of any of Examples above, wherein the signal property comprises an amplitude change, a rate of the amplitude change, a peak amplitude value, or a phase of the second electrical signal.
   Example 6. The apparatus of Example 5, wherein a rate of the amplitude change is larger in a portion of the second electrical signal compared to corresponding portion of the first electrical signal.
   Example 7. The apparatus of Example 5, wherein the second electrical signal is pre-emphasized or post-emphasized with respect to the first electrical signal.
   Example 8. The apparatus of Example 4, wherein the second electrical signal comprises an overshoot or an undershoot portion.
   Example 9. The apparatus of any of Examples above, wherein the first electrical signal comprises a periodic signal having a period and a local maximum of the second electrical signal lags a local minimum of the first electrical signal by an amount less than 50% of the period of the first electrical signal.
   Example 10. The apparatus of any of Examples above, wherein the absolute value of the local maximum of the second electrical signal is larger than the absolute value of the local minimum of the first electrical signal.
   Example 11. The apparatus of any of Examples above, wherein the first electrical signal comprises a periodic signal having a period and a local minimum of the second electrical signal leads a local maximum of the first electrical signal by an amount less than 50% of the period of the first electrical signal.
   Example 12. The apparatus of Example 11, wherein the absolute value of the local minimum of the second electrical signal is larger than the absolute value of the local maximum of the first electrical signal.
   Example 13. The apparatus of any of Examples above, wherein the first and the second electrical signals comprise periodic signals and a phase of the first electrical signal is shifted with respect to the second electrical signal by 180 degrees.
   Example 14. The apparatus of Example 12, wherein the second electrical signal is configured to operate the heat compensating device such that a difference between thermal energy generated and thermal energy dissipated by the optoelectronic device, averaged over a time interval, is less than a threshold value.
   Example 15. The apparatus of Example 14, wherein the threshold value is less than 5% of heat generated by the heat compensating device, averaged over the time interval.
   Example 16. The apparatus of Example 14, wherein the first electrical signal comprises a periodic signal having a period and the time interval comprises one or more of said period.
   Example 17. The apparatus of any of Examples above, wherein the heat compensating device comprises a second optoelectronic device.
   Example 18. The apparatus of Example 17, wherein the optoelectronic device and the second optoelectronic device are substantially identical.
   Example 19. The apparatus of Example 17, wherein the optoelectronic device comprises a first optical cavity formed between a first front mirror and a first back mirror, and the second optoelectronic device comprises a second optical cavity formed between a second front mirror and a second back mirror.
   Example 20. The apparatus of Example 19, wherein dimensions of the first optical cavity, the first front mirror, and the first back mirror are different from those of the second optical cavity, the second front mirror, and the second back mirror, respectively, by no more than 20%.
   Example 21. The apparatus of Example 19, wherein the first optical cavity comprises a first gain section and a first phase section, and the second optical cavity comprises a second gain section and a second phase section.
   Example 22. The apparatus of Example 21, wherein dimensions of the first phase section and the first gain section are different from those of the second phase section and the second gain section, respectively, by no more than 20%.
   Example 23. The apparatus of Example 17, wherein the first electrical signal is provided to a first section of the optoelectronic device and the second electrical signal is provided to a corresponding first section of the second optoelectronic device.
   Example 24. The apparatus of Example 23 wherein the electrical circuitry is further configured to provide a third electrical signal to a second section of the optoelectronic device and a fourth electrical signal to a corresponding second section the second optoelectronic device.
   Example 25. The apparatus of Example 24, wherein the electrical circuitry is configured to adjust a signal property of the fourth electrical signal based at least in part on a signal property of the third electrical signal.
   Example 26. The apparatus of Example 24, wherein the third electrical signal is a periodic signal having a period and a local maximum of the fourth electrical signal lags a local minimum of the third electrical signal by an amount less than 50% of the period of the first electrical signal.
   Example 27. The apparatus of Example 24, wherein the third electrical signal is a periodic signal having a period and a local minimum the fourth electrical signal lags a local maximum of the third electrical signal by an amount less than 50% of the period of the first electrical signal.
   Example 28. The apparatus of Example 19, wherein the optoelectronic device and second optoelectronic devices have the same design.
   Example 29. The apparatus of Example 19, wherein the optoelectronic device and second optoelectronic devices have different designs.
   Example 30. The apparatus of any of Examples above, wherein the heat compensating device and the optoelectronic device are formed on a common substrate.
   Example 31. The apparatus of any of Examples above, wherein the optoelectronic device comprises a wavelength tunable laser.
   Example 32. The apparatus of any of Examples above, wherein the optoelectronic device comprises at least one optical reflector, at least one optical gain section, the at least one optical reflector comprising an optical grating.
   Example 33. The apparatus of Example 32, wherein the first electrical signal is provided to the at least one optical reflector of the optoelectronic device.
   Example 34. The apparatus of any of Examples above, wherein the electrical circuitry is further configured to adjust the second electrical signal based at least in part on the first electrical signal to maintain wavelength variations of the optical signals generated by the optoelectronic device within a wavelength uncertainty limit.
   Example 35. The apparatus of any of Examples above, wherein the heat compensating device is in thermal communication with the optoelectronic device via a common substrate on which both the heat compensating device and the optoelectronic device are fabricated.
   Example 36. The apparatus of any of Examples above, wherein the heat compensating device comprises a thermoelectric device.
   Example 37. The apparatus of Example 36, wherein the thermoelectric device comprises a resistor, or a thermoelectric cooler.
   Example 38. The apparatus of Example 36, wherein the thermoelectric device comprises a film resistor or semiconductor junction.
   Example 39. The apparatus of any of Examples above, wherein the electrical circuitry is configured to provide the first electrical signal to a wavelength control section of the optoelectronic device to control the wavelength of the optical signal.
   Example 40. The apparatus of Example 39, wherein the wavelength control section comprises a mirror or a phase section.
   Example 41. The apparatus of any of Examples above, wherein the electrical circuitry is configured to provide the first electrical signal to a gain section of the optoelectronic device to control the amplitude of the optical signal.
   Example 42. The apparatus of any of Examples above, wherein said second electrical signal comprises a current and said current is modulated asymmetrically with respect to a bias current.
   Example 43. The apparatus of any of Examples above, wherein said second electrical signal comprises a current and said current is modulated asymmetrically with respect to a bias current so as to increase and decrease the amount of heat generated by the head compensating device by the same magnitude.

### Terminology

Conditional language, such as "can," "could," "might," or "may," unless specifically stated otherwise, or otherwise understood within the context as used, is generally intended to convey that certain embodiments include, while other embodiments do not include, certain features, elements, and/or steps. Thus, such conditional language is not generally intended to imply that features, elements, and/or steps are in any way required for one or more embodiments.

Conjunctive language such as the phrase "at least one of X, Y, and Z," unless specifically stated otherwise, is to be understood within the context used in general to convey that an item, term, etc. may be either X, Y, or Z. Thus, such conjunctive language is not generally intended to imply that certain embodiments require the presence of at least one of X, at least one of Y, and at least one of Z.

Language of degree, as used herein, such as the terms "approximately," "about," "generally," and "substantially," represent a value, amount, or characteristic close to the stated value, amount, or characteristic that still performs a desired function or achieves a desired result. For example, the terms "approximately," "about," "generally," and "substantially" may refer to an amount that is within ± 10% of, within ± 5% of, within ± 2% of, within ± 1% of, or within ± 0.1% of the stated amount. As another example, the terms "generally parallel" and "substantially parallel" refer to a value, amount, or characteristic that departs from exactly parallel by ± 10 degrees, by ± 5 degrees, by ± 2 degrees, by ± 1 degree, or by ± 0.1 degrees, and the terms "generally perpendicular" and "substantially perpendicular" refer to a value, amount, or characteristic that departs from exactly perpendicular by ± 10 degrees, by ± 5 degrees, by ± 2 degrees, by ± 1 degree, or by ± 0.1 degree.

Various configurations have been described above. Although this invention has been described with reference to these specific configurations, the descriptions are intended to be illustrative of the invention and are not intended to be limiting. Various modifications and applications may occur to those skilled in the art without departing from the true spirit and scope of the invention. Thus, for example, in any method or process disclosed herein, the acts or operations making up the method/process may be performed in any suitable sequence and are not necessarily limited to any particular disclosed sequence. Features or elements from various embodiments and examples discussed above may be combined with one another to produce alternative configurations compatible with embodiments disclosed herein. Various aspects and advantages of the embodiments have been described where appropriate. It is to be understood that not necessarily all such aspects or advantages may be achieved in accordance with any particular embodiment. Thus, for example, it should be recognized that the various embodiments may be carried out in a manner that achieves or optimizes one advantage or group of advantages as taught herein without necessarily achieving other aspects or advantages as may be taught or suggested herein.

The methods described herein are performed, in some examples, by software in machine readable form on a tangible, non-transitory storage medium, e.g., in the form of a computer program comprising computer program code adapted to perform the operations of one or more of the methods described herein when the program is run on a computer and where the computer program may be embodied on a non-transitory computer readable medium. The software is suitable for execution on a parallel processor or a serial processor such that the method operations may be carried out in any suitable order, or simultaneously.

This acknowledges that software is a valuable, separately tradable commodity. It is intended to encompass software, which runs on or controls "dumb" or standard hardware, to carry out the desired functions. It is also intended to encompass software which "describes" or defines the configuration of hardware, such as HDL (hardware description language) software, as is used for designing silicon chips, or for configuring universal programmable chips, to carry out desired functions.

Those skilled in the art will realize that storage devices utilized to store program instructions are optionally distributed across a network. For example, a remote computer is able to store an example of the process described as software. A local or terminal computer is able to access the remote computer and download a part or all of the software to run the program. Alternatively, the local computer may download pieces of the software as needed, or execute some software instructions at the local terminal and some at the remote computer (or computer network). Those skilled in the art will also realize that by utilizing conventional techniques known to those skilled in the art that all, or a portion of the software instructions may be carried out by a dedicated circuit, such as a digital signal processor (DSP), programmable logic array, or the like.

Any range or device value given herein may be extended or altered without losing the effect sought, as will be apparent to the skilled person.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

It will be understood that the benefits and advantages described above may relate to one embodiment or may relate to several embodiments. The embodiments are not limited to those that solve any or all of the stated problems or those that have any or all of the stated benefits and advantages. No single feature or group of features is necessary or indispensable to every embodiment.

Any processes, blocks, states, steps, or functionalities in flow diagrams described herein and/or depicted in the attached figures should be understood as potentially representing code modules, segments, or portions of code which include one or more executable instructions for implementing specific functions (e.g., logical or arithmetical) or steps in the process. The various processes, blocks, states, steps, or functionalities can be combined, rearranged, added to, deleted from, modified, or otherwise changed from the illustrative examples provided herein. In some embodiments, additional or different computing systems or code modules may perform some or all of the functionalities described herein. The methods and processes described herein are also not limited to any particular sequence, and the blocks, steps, or states relating thereto can be performed in other sequences that are appropriate, for example, in serial, in parallel, or in some other manner. Tasks or events may be added to or removed from the disclosed example embodiments. Moreover, the separation of various system components in the implementations described herein is for illustrative purposes and should not be understood as requiring such separation in all implementations. It should be understood that the described program components, methods, and systems can generally be integrated together in a single computer product or packaged into multiple computer products. Many implementation variations are possible.

## Claims

1. An apparatus comprising:
an optoelectronic device configured to generate optical signals;
an heat compensating device in thermal communication with the optoelectronic device; and
electrical circuitry configured to provide at least a first electrical signal to the optoelectronic device and at least a second electrical signal to the heat compensating device to controllably adjust a temperature of the optoelectronic device;
wherein the electrical circuitry is further configured to adjust a signal property of the second electrical signal based at least in part on a signal property of the first electrical signal to reduce a delay between a change in the second electrical signal and a corresponding adjustment in the temperature of the optoelectronic device.

2. The apparatus of claim 1, wherein the signal property comprises an amplitude change, a rate of the amplitude change, a peak amplitude value, or a phase of the second electrical signal.

3. The apparatus of claim 2, wherein the second electrical signal is pre-emphasized or post-emphasized with respect to the first electrical signal.

4. The apparatus of claim 3, wherein the second electrical signal comprises an overshoot or an undershoot portion.

5. The apparatus of claim 1, wherein the first electrical signal comprises a periodic signal having a period and a local maximum of the second electrical signal lags a local minimum of the first electrical signal by an amount less than 50% of the period of the first electrical signal.

6. The apparatus of claim 5, wherein the absolute value of the local maximum of the second electrical signal is larger than the absolute value of the local minimum of the first electrical signal.

7. The apparatus of claim 1, wherein the first electrical signal comprises a periodic signal having a period and a local minimum of the second electrical signal leads a local maximum of the first electrical signal by an amount less than 50% of the period of the first electrical signal.

8. The apparatus of claim 7, wherein the absolute value of the local minimum of the second electrical signal is larger than the absolute value of the local maximum of the first electrical signal.

9. The apparatus of claim 8, wherein the second electrical signal is configured to operate the heat compensating device such that a difference between thermal energy generated and thermal energy dissipated by the optoelectronic device, averaged over a time interval, is less than a threshold value.

10. The apparatus of claim 1, wherein the heat compensating device comprises a second optoelectronic device.

11. The apparatus of claim 10, wherein the optoelectronic device comprises a first optical cavity formed between a first front mirror and a first back mirror, and the second optoelectronic device comprises a second optical cavity formed between a second front mirror and a second back mirror.

12. The apparatus of claim 11, wherein dimensions of the first optical cavity, the first front mirror, and the first back mirror are different from those of the second optical cavity, the second front mirror, and the second back mirror, respectively, by no more than 20%.

13. The apparatus of claim 10, wherein the first electrical signal is provided to a first section of the optoelectronic device and the second electrical signal is provided to a corresponding first section of the second optoelectronic device.

14. The apparatus of claim 13 wherein the electrical circuitry is further configured to provide a third electrical signal to a second section of the optoelectronic device and a fourth electrical signal to a corresponding second section the second optoelectronic device.

15. The apparatus of claim 14, wherein the electrical circuitry is configured to adjust a signal property of the fourth electrical signal based at least in part on a signal property of the third electrical signal.

16. The apparatus of claim 15, wherein the third electrical signal is a periodic signal having a period and a local maximum of the fourth electrical signal lags a local minimum of the third electrical signal by an amount less than 50% of the period of the first electrical signal.

17. The apparatus of claim 15, wherein the third electrical signal is a periodic signal having a period and a local minimum the fourth electrical signal lags a local maximum of the third electrical signal by an amount less than 50% of the period of the first electrical signal.

18. The apparatus of claim 1, wherein the optoelectronic device comprises a wavelength tunable laser.

19. The apparatus of claim 1, wherein the heat compensating device comprises a thermoelectric device.

20. The apparatus of claim 19, wherein the thermoelectric device comprises a resistor, or a thermoelectric cooler.
